# EUROPEAN PATENT SPECIFICATION

(11) **EP 2 884 826 B1**
(45) Date of publication and mention of the grant of the patent: **14.08.2019**
(21) Application number: 14189826.2
(22) Date of filing: 22.10.2014
(51) Int. Cl.: H05K 5/06, H03K 17/95, G01D 11/24

(54) **Electronic device**
Elektronische Vorrichtung
Dispositif électronique

(30) Priority: 13.12.2013 JP 2013258625
(43) Date of publication of application: 17.06.2015
(73) Proprietor: OMRON CORPORATION, Kyoto, Kyoto 600-8530 (JP)
(72) Inventor: Nishikawa, Kazuyoshi, Kyoto, Kyoto 600-8530 (JP)
(74) Representative: Horn Kleimann Waitzhofer Patentanwälte PartG mbB

(56) References cited:
- JP-A- H0 992 105
- US-A- 5 293 002
- US-A1- 2013 015 981

## Description

### FIELD

The present invention relates to an electronic device, and in particular to an electronic device that is filled with a thermoplastic resin or a thermosetting resin so as to have a sealing property.

### BACKGROUND

JP H09-092105A discloses a configuration that is provided with a resin inlet through which a resin is injected.

JP H09-092105A is an example of background art.

### SUMMARY

In a device disclosed in the above-noted JP H09-092105A, if a resin having a low hardness is used in order to suppress a sealing-resin-derived stress damage from affecting on electronic components and the like, the sealing resin will expand when the device is used under a high-temperature environment since resins having a low hardness typically have a high linear expansion coefficient (for example, a linear expansion coefficient of 90×10⁻⁶/°C or more), and possibly run out from inside the case, which is a closed space, through an opening (for example, an injection gate for a filling resin).

When such running-out of a sealing resin from inside the case occurs, an external appearance of a product may be damaged, and the sealing resin that has run out from inside the case may be mixed, as a foreign substance, into an environment in which the electronic device is used. Furthermore, the loss of the sealing resin may deteriorate the sealing property of the inside of the case and the water resistance of the electronic device.

It is an object of the present invention to provide an electronic device that prevents a resin with which the device is filled from running out from an opening (for example, an injection gate) due to thermal expansion of the resin, even when the device is produced using a resin (for example, a hot melt resin) having a linear expansion coefficient of 90×10⁻⁶/°C (90 ppm/°C) or more, and is used under a high-temperature environment (for example, 50°C or more).

An electronic device according to the present invention includes: a casing that is tubular and whose one end is closed; a closing member that closes an opening at the other end of the casing; an electronic component that is arranged at a position enclosed by the casing and the closing member; and a resin section that fills up the inside of the casing and has a linear expansion coefficient of at least 90×10⁻⁶/°C and at most 400×10⁻⁶/°C. The casing is provided with a gate for filling of the resin section, the gate being in communication with the inside and outside of the casing. The electronic device is further provided with a filling resin confining surface inside of the casing, the filling resin confining surface being at least partially arranged at a position opposite to the gate, and including a region that has a distance to an inner surface of the casing of at least 0.2 mm and at most 1.0 mm and that has an area of at least four times the cross-sectional area of the gate.

When such a configuration is adopted, more stress due to resin expansion occurs in the longitudinal direction than in the thickness direction (that is, the relationship "stress in longitudinal direction > stress in thickness direction" is satisfied), and thus the stress that occurs due to resin expansion when the device is used under a high-temperature environment (for example, 50°C or more) can be absorbed in the longitudinal direction, that is, into the sealing resin. As a result, it is possible to satisfy both requirements of the resin running-out suppression effect and the fillability with resin.

Note that the above-described casing may have any cross-sectional shape as long as the casing is tubular. The cross-sectional shape may be a circle or any type of polygon.

It is preferable that the gate has a cross-sectional area that corresponds to an opening area of a circle whose diameter is in a range from 1.0 mm to 3.0 mm.

By adopting such a configuration, it is possible to satisfy both requirements of the resin running-out suppression effect and the fillability with resin.

Alternatively, the opening of the gate may not necessarily have the shape of a precise circle, but rather that of a polygon or ellipse. Note, however, that the gate is preferably configured to have a cross-sectional area that corresponds to an opening area of a circle whose diameter is in a range from 1.0 mm to 3.0 mm.

It is preferable that the closing member includes a main part whose outer circumferential surface is configured to be in contact with an inner surface of the casing, and the filling resin confining surface is formed in one piece with the main part and arranged at the position opposite to the gate.

By adopting such a configuration, it is possible to satisfy both requirements of the resin running-out suppression effect and the fillability with resin.

It is further preferable that the filling resin confining surface includes a member that extends in an axial direction of the casing, and both sides with respect to the extending direction of the member are configured to be in contact with the inner surface of the casing over a predetermined length range in parallel to the axial direction of the casing.

By eliminating a gap between the filling resin confining surface and the inner surface of the casing in this way, it is possible to separate a space in the vicinity of the gate from another space using the filling resin confining surface, mitigating the influence of running-out of the resin from the vicinity due to resin expansion.

Alternatively, it is preferable that the filling resin confining surface includes a member that extends in the axial direction of the casing, and a gap is formed between the member and the inner surface of the casing.

By adopting such a configuration, it is possible to enhance the flowability of the resin during filling, and to improve the fillability with the resin.

Alternatively, it is further preferable that the filling resin confining surface has, on a surface thereof that is opposite to the gate, a groove section extending in the axial direction of the casing.

By providing such a groove section for guiding a resin in the axial direction of the casing, it is possible to increase the surface area of the resin that is adhered to the filling resin confining surface, further improving the sealing property.

Alternatively, it is further preferable that the filling resin confining surface is arc-shaped such that the surface opposite to the gate is convex when viewed in a cross section in a direction that is orthogonal to the axial direction of the casing.

By adopting such a configuration, it is possible to enhance the flowability of the resin during filling, and improve the fillability with the resin.

It is preferable that the closing member includes a first section at least a part of whose outer circumferential surface is configured to be in contact with the inner surface of the casing, and a second section that is formed in one piece with the first section and has a smaller shape than that of the first section when viewed in the cross section in a direction that is orthogonal to the axial direction of the casing. The filling resin confining surface includes an outer circumferential surface of the second section.

It is further preferable that the first section has a cut-out section that is configured to be continuous with the outer circumferential surface of the second section.

Alternatively, it is further preferable that a pair of projections that extends in the axial direction of the casing is provided on the outer surface of the second section, and the closing member is arranged such that a space between the pair of projections is in communication with the gate.

By providing such a groove section for guiding a resin in the axial direction of the casing, it is possible to increase the surface area of the resin that is adhered to the filling resin confining surface, further improving the sealing property.

It is further preferable that a projection that extends in a circumferential direction is provided on the outer circumferential surface of the second section on the side that is opposite to the inner surface of the casing.

By adopting such as structure, it is possible to increase the surface area of the resin that is adhered to the filling resin confining surface, further improving the sealing property.

Alternatively, it is further preferable that the closing member includes a main part whose outer surface is configured to be in contact with the inner surface of the casing, the main part has a cut-out section that is configured such that a distance between an outer surface of the cut-out section and the inner surface of the casing is in a range from 0.2 mm to 1.0 mm, and the closing member is arranged such that the cut-out section is in communication with the gate.

Since such a relatively simple structure is adopted, it is possible to improve the yield of the closing member.

Alternatively, it is further preferable that the casing has, on one end thereof, a fitting section to which the closing member is fitted, and the fitting section is configured such that an inner surface thereof to which the closing member is fitted has a smaller cross-sectional shape in the direction that is orthogonal to the axial direction of the casing than that of another section of the casing, and has a hollow structure that is in communication with the inside of the casing, and the gate is provided close to the fitting section, and the thickness of the hollow structure is configured to be in a range from 0.2 mm to 1.0 mm.

Since the filling resin confining surface is formed on the casing, processing is simplified. Therefore, it is possible to improve the yield of the entire device.

Alternatively, it is further preferable that the casing has, on one end thereof, a fitting section to which the closing member is fitted and that is configured such that an inner surface thereof to which the closing member is fitted has a smaller cross-sectional shape than that of another section of the casing, and has a hollow structure that is in communication with the inside of the casing, the thickness of the hollow structure is configured to be in a range from 0.2 mm to 1.0 mm, the closing member includes a main part that is in contact with the inner surface of the fitting section, and a projection whose outer circumferential surface is continuous with the inner surface of the hollow structure, and the gate is provided in a section that is opposite to the fitting section or a section that is opposite to the projection of the closing member, and a surface that is opposite to the gate serves as the filling resin confining surface.

By adopting such a structure, it is possible to realize the resin running-out suppression effect using the filling resin confining surface.

An electronic device according to the present embodiment includes: a casing that is tubular and whose one end is closed; an electronic component that is arranged at a position enclosed by the casing; and a resin section that fills up the inside of the casing and has a linear expansion coefficient of at least 90×10⁻⁶/°C and at most 400×10⁻⁶/°C. The casing has, on the other end thereof, a projection whose inner surface has a smaller cross-sectional shape (cross-sectional dimension) than that of another section of the casing, and that has a hollow structure that is in communication with the inside of the casing, the casing is provided with a gate for filling of the resin section, the gate being in communication with the inside and outside of the casing, and the hollow structure of the projection defines the thickness of the resin section that is filled with a resin from the gate in a range from 0.2 mm to 1.0 mm.

An application temperature of the above-described electronic device is in a range from -30°C to 85°C.

According to the electronic device of the present invention, even when the electronic device is manufactured using a resin (for example, a hot melt resin) having a linear expansion coefficient of 90×10⁻⁶/°C (90 ppm/°C) or more, and is used under a high-temperature environment (for example, 50°C or more), it is possible to prevent the resin with which the electronic device is filled from running out from an opening (for example, the injection gate) due to thermal expansion.

### BRIEF DESCRIPTION OF THE DRAWINGS

FIG. 1 is a perspective view illustrating a proximity sensor according to the present embodiment.
FIG. 2 is an exploded perspective view of the proximity sensor of the present embodiment.
FIG. 3 is a cross-sectional view taken along the line III-III of FIG. 1.
FIG. 4 is a cross-sectional view taken along the line IV-IV of FIG. 1.
FIG. 5 is an enlarged cross-sectional view illustrating the vicinity of a detecting unit included in the proximity sensor of the present embodiment.
FIG. 6 is a perspective view schematically illustrating a film gate member, which realizes a filling resin confining surface of the present embodiment.
FIG. 7 is a cross-sectional view taken along the line VII-VII of FIG. 6.
FIG. 8 shows schematic diagrams illustrating resin injection processing using the film gate member of the present embodiment.
FIG. 9 shows schematic diagrams illustrating a film gate member and a proximity sensor including the film gate member, according to Embodiment 1.
FIG. 10 shows schematic diagrams illustrating a film gate member according to Modification 1 of Embodiment 1.
FIG. 11 shows schematic diagrams illustrating a film gate member according to Modification 2 of Embodiment 1.
FIG. 12 is a schematic diagram illustrating a film gate member according to Modification 3 of Embodiment 1.
FIG. 13 shows schematic diagrams illustrating a film gate member and a proximity sensor including the film gate member, according to Embodiment 2.
FIG. 14 are schematic diagrams illustrating a film gate member and a proximity sensor including the film gate member, according to Embodiment 3.
FIG. 15 shows schematic diagrams illustrating a film gate member and a proximity sensor including the film gate member, according to Embodiment 4.
FIG. 16 shows schematic diagrams illustrating a film gate member and a proximity sensor including the film gate member, according to Embodiment 5.
FIG. 17 is a perspective view illustrating a proximity sensor according to Embodiment 6.
FIG. 18 is a schematic diagram illustrating a film gate member according to Embodiment 6.
FIG. 19 shows schematic diagrams illustrating a film gate member and a proximity sensor including the film gate member, according to Embodiment 7.
FIG. 20 shows schematic diagrams illustrating a film gate section according to Embodiment 8.

### DETAILED DESCRIPTION

Hereinafter, embodiments and examples according to the present invention will be described with reference to the drawings. In the description of the embodiments and examples, when the number of pieces, amount, and the like are mentioned, the scope of the present invention is not necessarily limited to that number of pieces, amount, and the like, unless otherwise noted. In the description of embodiments and examples, the same reference numerals are given to the same members and corresponding members, and descriptions thereof may not be repeated.

In the following description, a proximity sensor will be described as an example of an electronic device according to the present invention, but the present invention is not limited thereto and can be implemented as various types of electronic devices. Note however that the present invention can be preferably implemented as any of various types of sensors, taking the sealing property of the electronic device according to the present invention into consideration.

### [Overall Configuration]

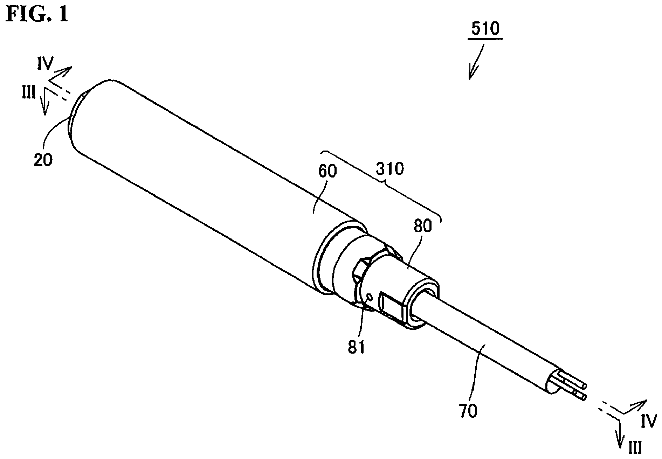

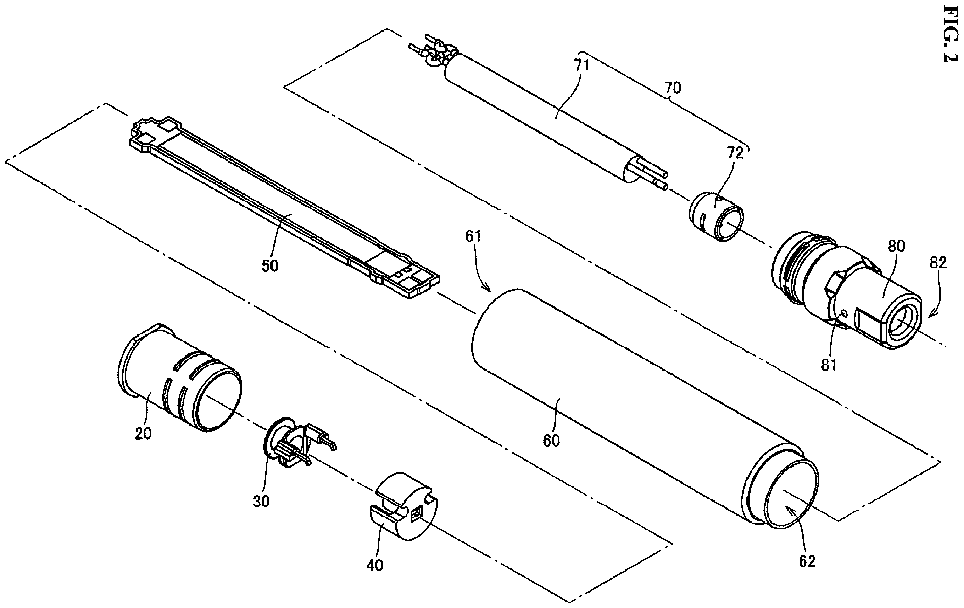

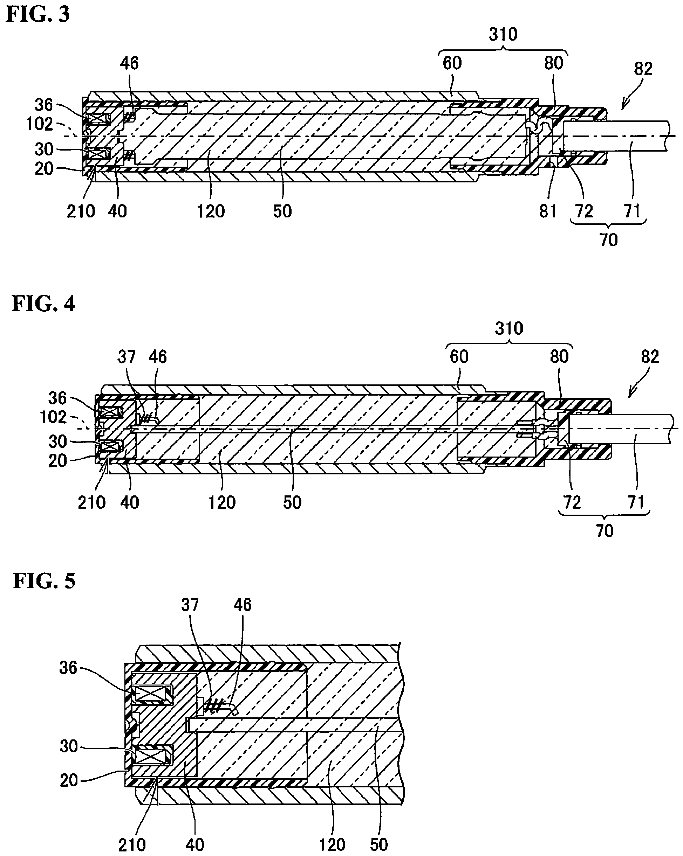

First, a proximity sensor 510 according to the present embodiment will be described with reference to FIGS. 1 to 5. FIG. 1 is a perspective view illustrating the proximity sensor 510 of the present embodiment. FIG. 2 is an exploded perspective view of the proximity sensor 510 of the present embodiment. FIG. 3 is a cross-sectional view taken along the line III-III of FIG. 1. FIG. 4 is a cross-sectional view taken along the line IV-IV of FIG. 1. FIG. 5 is an enlarged cross-sectional view illustrating the vicinity of a detecting unit 210 included in the proximity sensor 510 of the present embodiment.

Referring to FIGS. 1 to 5, the proximity sensor 510 is an inductive proximity sensor that generates a magnetic field in a detection region to detect whether or not a detection target is approaching or present. The detection target that is detected by the proximity sensor 510 is a conductive object. The detection target that is detected by the proximity sensor 510 typically includes magnetic metal such as iron. The detection target that is detected by the proximity sensor 510 may also include a nonmagnetic metal such as copper or aluminum.

The proximity sensor 510 has an outer appearance extending cylindrically along a phantom central axis 102 (see FIGS. 3 and 4). The proximity sensor 510 includes the detecting unit 210 (see FIGS. 3 to 5), a coil case 20, a printed board 50 (see FIGS. 2 to 5), a base metal fitting 60, which serves as a housing, a clamp 80, and a ring cord 70.

The detecting unit 210 detects whether or not a detection target is approaching or present. As an example, the detecting unit 210 generates a magnetic field by flowing a current through a coil, and detects whether or not a detection target is approaching or present using an electromagnetic interaction between the generated magnetic field and the detection target. The detecting unit 210 is provided on the front end side of the proximity sensor 510 that faces the detection region. The detecting unit 210 mainly includes a core 40, an electromagnetic coil 36 (see FIGS. 3 to 5), and a coil spool 30 (see FIGS. 2 to 5).

The core 40 is made from, for example, a material having an excellent high frequency property, such as ferrite. The core 40 has functions to increase the coil characteristics of the detecting unit 210, and to concentrate magnetic fluxes in the detection region. The electromagnetic coil 36 is a coil wire and wound on the coil spool 30. The electromagnetic coil 36 is wound around the central axis 102. According to the present embodiment, the central axis around which the electromagnetic coil 36 is wound is configured to be identical with the central axis 102.

The coil spool 30 is made from an electric insulating resin. The coil spool 30 is accommodated in a circular groove formed in the core 40. A coil pin 46 is made from conductive metal. The coil pin 46 is supported by the coil spool 30. The coil pin 46 extends from the detecting unit 210 to the printed board 50. The end of the extending coil pin 46 is connected to a conductive region formed on the printed board 50.

An end 37 of the electromagnetic coil 36 that is drawn from the outer circumference of the coil spool 30 is wound around the root section of the coil pin 46 that extends from the detecting unit 210. The electromagnetic coil 36 and the printed board 50 are electrically connected to each other via the coil pin 46 and solder (not shown).

The detecting unit 210 is accommodated in the coil case 20. The coil case 20 functions as a front cover that is mounted in an opening 61 on the front end side of the base metal fitting 60. The coil case 20 is typically made from a material such as a thermoplastic resin that has an excellent adhesiveness to a resin constituting a resin section 120. A material of the coil case 20 may appropriately be selected from, for example, ABS, PC (polycarbonate), POM (polyacetal), PBT (polybutylene terephthalate), PA (polyamide), PE (polyethylene), PP (polypropylene), PES (polyether sulfone), PPS (Polyphenylenesulfide), LCP (liquid crystal polymer), and PS (polystyrene), and mixtures thereof.

The coil case 20 is provided so as to serve as a cover for the front end side on which the detecting unit 210 is accommodated. The coil case 20 fills up the opening 61 on the front end side of the base metal fitting 60, which serves as a casing. The coil case 20 has the shape of a cylinder with a bottom, and is provided mainly for blocking and protecting the detecting unit 210 from the outer atmosphere.

The coil case 20 cylindrically extends along the central axis 102, and has such a shape that one end thereof is closed and the other end thereof is open. The end face of the coil case 20 on the closed end side constitutes a detection surface of the proximity sensor 510. The detecting unit 210 is arranged inside of the tubular section of the coil case 20.

The printed board 50 has an elongated flat plate shape. The printed board 50 extends such that the longitudinal direction thereof is the axial direction of the central axis 102. Various types of electronic components (not shown), such as a transistor, a diode, a resistor, and a capacitor, are mounted on the printed board 50. These electronic components are also sealed by a resin, and encompass components that are electrically connected to the detecting unit 210.

The base metal fitting 60 functions as a tubular casing for accommodating the electronic components such as a transistor, a diode, a resistor, and a capacitor. The base metal fitting 60, serving as the casing, is closed by the coil case 20 on one end (opening 61 on the front end side). The base metal fitting 60 forms a contour of the proximity sensor 510 at a certain distance from the central axis 102. The base metal fitting 60 has the shape of cylindrically extending along the central axis 102. The shape of the base metal fitting 60 is not limited to a cylinder, and the casing may have another cylindrical shape such as a rectangular tube, a multiangular tube, or an elliptic tube. The casing may be made from a resin member.

The base metal fitting 60 extends around the central axis 102 and is open on its two ends. The base metal fitting 60 has the opening 61 on the front end side in the longitudinal direction, and an opening 62 on the rear end side in the longitudinal direction. The openings 61 and 62 communicate with each other via the internal space formed inside an inner surface 63 of the base metal fitting 60. The inner surface 63 of the present embodiment is precisely circular, when seen in the cross-sectional view in the direction that is orthogonal to the central axis 102, at any position in the direction in which the central axis 102 extends.

The base metal fitting 60 is made from metal. The base metal fitting 60 includes, on its outer circumferential surface, a screw for use for fixing the proximity sensor 510 to external equipment. The above-described coil case 20 is inserted into the opening 61 of the base metal fitting 60 on its front end side, and is fixed to the base metal fitting 60. That is, one end (the opening 61 on the front end side) of the base metal fitting 60, which is the tubular casing, is closed by the coil case 20. Furthermore, the ring cord 70 and the clamp 80 together close the opening (opening 62 on the rear end side) on the other end of the base metal fitting 60, which is the tubular casing. In other words, the ring cord 70 and the clamp 80 function as closing members for closing the opening on the other end of the casing.

The clamp 80 is provided as a connection member that is connected to the base metal fitting 60 from the rear end side of the proximity sensor 510. The clamp 80 is incorporated into one piece with the base metal fitting 60 on the rear end side so as to constitute a cylindrical case 310. The clamp 80 is connected to the rear end of the cylindrical base metal fitting 60. The clamp 80 is inserted into the opening 62 of the base metal fitting 60 on its rear end side. The clamp 80, together with the base metal fitting 60, extends cylindrically along the central axis 102. The clamp 80 has an injection gate 81. The injection gate 81 is provided as a through-hole through which a resin is injected into the cylindrical case 310 when the proximity sensor 510 is manufactured. The injection gate 81 is used for filling of the resin section 120 from the side surface of the cylindrical case 310, and is in communication with the inside and outside of the base metal fitting 60, which is the casing.

The clamp 80 is made from a material having a lower linear expansion coefficient than that of a filling resin, that is, a material that has a high hardness. Such a material of the clamp 80 may appropriately be selected from, for example, ABS, PC (polycarbonate), POM (polyacetal), PBT (polybutylene terephthalate), PA (polyamide), PE (polyethylene), PP (polypropylene), PES (polyether sulfone), PPS (Polyphenylenesulfide), LCP (liquid crystal polymer), PS (polystyrene), and mixtures thereof. A peripheral component that is incorporated into one piece with the clamp 80 and will be described later is also made from such a material.

The ring cord 70 is an external connection member, and electrically connected to the printed board 50 inside of the base metal fitting 60. The ring cord 70 is inserted into the clamp 80 and drawn from an opening 82 on the rear end side of the clamp 80. The ring cord 70 closes the opening 82 on the rear end side of the clamp 80.

The ring cord 70 includes a cable 71 and a ring member 72. The ring member 72 is provided so as to cover an end of the cable 71 in the cylindrical case 310. The ring member 72 ensures connectivity between the resin section 120 in the cylindrical case 310 and the cable 71, the resin section 120 being described later. The ring member 72 is made from, for example, PBT (polybutylene terephthalate). The cable 71 is covered with, for example, polyvinyl chloride.

The resin section 120 is formed by filling the inside of the cylindrical case 310 with a resin. In the proximity sensor 510, a case member for accommodating the detecting unit 210 and the printed board 50 is configured by the cylindrical case 310, the ring cord 70, and the coil case 20. The resin section 120 is provided so as to fill up the accommodation space in this case member that is surrounded by the cylindrical case 310, and the coil case 20 and the ring cord 70, which close the front and rear ends of the cylindrical case 310. The resin section 120 seals the detecting unit 210 accommodated in the coil case 20, and the printed board 50 and the electronic components accommodated in the cylindrical case 310.

In the state in which the base metal fitting 60, the coil case 20, the ring cord 70, and the clamp 80 are assembled together, an accommodation space is formed inside of these components. In the state in which the proximity sensor 510 has been manufactured, the printed board 50 and the electronic components are located, together with the resin section 120, in the accommodation space. That is, the printed board 50 and the electronic components are arranged in the internal space enclosed by the base metal fitting 60, which serves as the casing, and the ring cord 70 and the clamp 80, which serve as the closing members.

### [Resin Section 120]

The resin of the resin section 120 that is injected through the injection gate 81 is selected from, for example, a thermoplastic resin, a thermosetting resin, a light curable resin, an ultraviolet curable resin, and a moisture curable resin. Typically, a resin of the resin section 120 is selected from a thermoplastic resin and a thermosetting resin. The resin section 120 fills up the inside of the base metal fitting 60, which is the casing, and seals the detecting unit 210 (the core 40, the electromagnetic coil 36, and the coil spool 30), and the like.

A resin having a low hardness is used for the resin section 120 so as to reduce the stress on internal devices such as the electronic components and the printed board 50. Examples of such a resin having a low hardness typically include a material whose linear expansion coefficient is at least 90×10⁻⁶/°C and at most 400×10⁻⁶/°C. Note that any material can be selected for a material of the constituent components of the housing that is filled with a resin, as long as the material has a hardness that is higher than that of the resin section 120 and a resistance (rigidity) against the deformation of the resin section 120.

According to the present embodiment, even when such a resin having a high linear expansion coefficient is used, it is possible to prevent the phenomenon that the resin runs out to the outside by adopting the structure that will be described later. Therefore, even when the device is used under a high-temperature environment (for example, 50°C or more), it is possible to ensure the sealing properties.

The thermoplastic resin that is used for formation of the resin section 120 may be at least one type selected from the group of polyolefins, polyesters, and polyamides, for example. The thermoplastic resin that is used for formation of the resin section 120 may include various types of additive agents such as a flame retarder, an organic/inorganic filler, a plasticizer, a coloring agent, and an antioxidant. Note that the thermoplastic resin that is used for formation of the resin section 120 is preferably a so-called hot melt resin.

On the other hand, when a thermosetting resin is used, an epoxy resin is typically used. The resin section 120 preferably has a low variation in resin stress (relaxation of stress) that is affected on the detecting unit 210. The thermosetting resin that is used for the resin section 120 is preferably a resin whose elastic modulus at ambient temperature is 800 MPa or more. The thermosetting resin that is used for the resin section 120 may include various types of additive agents such as a flame retarder, an organic/inorganic filler, a plasticizer, a coloring agent, and an antioxidant.

In the state in which the proximity sensor 510 has been manufactured, the resin section 120 has a shape extending from the coil case 20 (one opening 61) to the ring cord 70 and clamp 80 (the other opening 62).

The cylindrical case 310 according to the present embodiment includes, as a part of the configuration thereof, a filling resin confining surface. The filling resin confining surface is a mechanism that prevents the filling resin from running out from the injection gate 81 or the like even when the device is used under a high-temperature environment (for example, 50°C or more). More specifically, the thickness of the resin section that is formed at the injection gate 81 and surrounding structures (hereinafter, referred to as "gate surrounding section") is reduced so as to suppress the resin section from running out due to thermal expansion.

The inventors of the present application found a method for suppressing the total amount of thermal expansion occurring to a filling resin in order to prevent running-out of the filling resin. The total amount of thermal expansion occurring to a filling resin correlates with the total volume of the filling resin that is present in the gate surrounding section. Accordingly, the inventors of the present application found a new fact that optimizing the total volume of the filling resin that is present in the gate surrounding section within the scope in which the fillability with resin is not sacrificed enables a significant suppression of the total amount of thermal expansion, preventing running-out of the filling resin.

### [Filling resin confining surface]

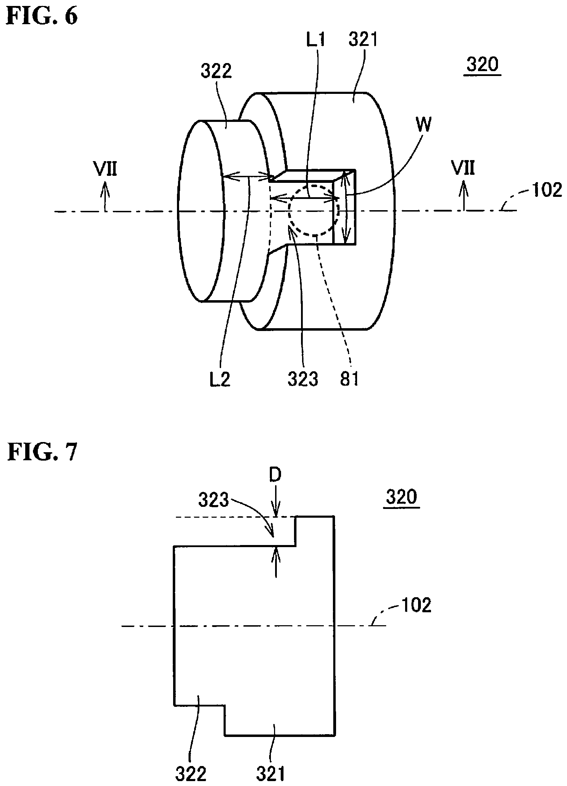

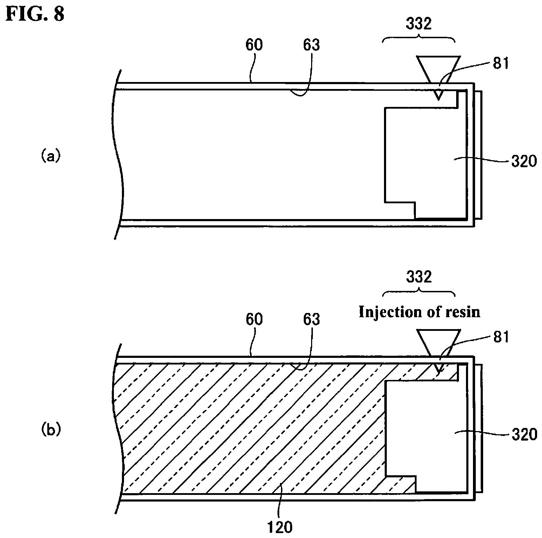

First, the filling resin confining surface according to the present embodiment will be described conceptually with reference to FIGS. 6 to 8. FIG. 6 is a perspective view schematically illustrating a film gate member that realizes the filling resin confining surface according to the present embodiment. FIG. 7 is a cross-sectional view taken along the line VII-VII of FIG. 6. FIG. 8 shows schematic diagrams illustrating resin injection processing using the film gate member according to the present embodiment.

Referring to FIGS. 6 and 7, a film gate member 320 according to the present embodiment optimizes the total volume of a filling resin that is present in the gate surrounding section 332 within the scope in which the fillability with resin is not sacrificed. Note that the term "film gate member" means a structure in which the thickness of the resin section formed under and around the injection gate 81 is reduced and injected in the shape of a film.

The film gate member 320 shown in FIGS. 6 and 7 has, for example, a sealing step structure. Specifically, the film gate member 320 has a configuration in which a first cylindrical section 321 that has a larger cross-sectional area (cross sectional radius) when viewed in the cross section in the direction that is orthogonal to the axial direction of the central axis 102, and a second cylindrical section 322 that has a smaller cross-sectional area (cross sectional radius) than that of the first cylindrical section 321 are adjacent and connected to each other, and a part of the outer surface of the first cylindrical section 321 is cut out. That is, the first cylindrical section 321 (first section) is provided with a cut-out section that is configured to be continuous with the outer surface of the second cylindrical section 322 (second section). This cut-out section on the outer surface of the first cylindrical section 321 corresponds to a film gate section 323. With this cut-out section, at least a part of the outer surface of the first cylindrical section 321 is in contact with the inner surface of the base metal fitting 60 (casing). The film gate section 323 is positioned so as to correspond to the position of the injection gate 81.

As shown in FIGS. 8(a) and 8(b), a resin that is to be injected through the injection gate 81 will pass through the film gate section 323 and fill up the internal space of the base metal fitting 60 on the left side of the drawings. Since a part other than the section that is cut out as the film gate section 323 remains on the outer circumferential surface of the first cylindrical section 321, the outer circumferential surface of the first cylindrical section 321 is contiguous with the base metal fitting 60 on the rear end side, thereby sealing the filling resin. When filling with the resin is completed, the resin section 120 is formed in the internal space formed inside of the base metal fitting 60.

In the state in which filling with the resin is completed as shown in FIG. 8(b), the filling resin having the size that corresponds to the size of the film gate section 323 (that is, the volume of the cut-out section) is present in the gate surrounding section 332. The inventors of the present application found it preferable to determine the size of the film gate section 323 according to the following conditions in order to prevent running-out of the sealing resin from inside the case, taking into consideration the relationship with the injection gate 81.
(1) A distance (thickness D of the section filled with a resin in the film gate section 323) between the filling resin confining surface and the inner surface 63 of the base metal fitting 60 is in the range from 0.2 mm to 1.0 mm; and
(2) An area of the filling resin confining surface (circumferential direction width W × axial direction length L1) is at least four times larger than the cross-sectional area of the injection gate 81.

Note that the linear expansion coefficient of the filling resin is in the range from 90×10⁻⁶/°C to 400×10⁻⁶/°C, and an application temperature of the proximity sensor 510 (electronic device) is in the range from -30°C to 85°C.

In view of optimization (reduction) of the total volume of the filling resin, the film gate member 320 has a thin resin-filled structure. Furthermore, the thin resin-filled structure of the film gate member 320, and the filling resin are adhered to each other partially or entirely.

Note that a difference (a difference in radius) between the first cylindrical section 321 and the second cylindrical section 322 is preferably in the range from 0.2 mm to 1.0 mm, and an axial direction length L2 of the second cylindrical section 322 is preferably in the range from 0.5 mm to 10.0 mm. Furthermore, the axial direction length L1 of the film gate section 323 preferably is not greater than the value obtained by adding 20.0 mm to the axial direction length L2 of the second cylindrical section 322. On the other hand, the circumferential direction width W of the film gate section 323 may be designed to any value. That is, the film gate section 323 may have not only the structure as shown in FIGS. 6 and 7, in which a part is cut out, but also the structure as described later in which the film gate section is provided over the entire circumference. That is, by using a film gate member that has the thin resin-filled structure and that enables filling with the resin in the entire circumferential direction, it is possible to improve the sealing property.

Accordingly, in the present embodiment, the filling resin confining surface is provided inside of the base metal fitting 60, which serves as the casing, and includes a position opposite to the injection gate 81, and a region that has a distance to the inner surface 63 of the base metal fitting 60 of at least 0.2 mm to at most 1.0 mm and that has an area of at least four times the cross-sectional area of the injection gate 81.

When the injection gate 81 has an opening that has the shape of a precise circle, it is preferable to design the opening to have a diameter between 1.0 mm and 3.0 mm. Alternatively, the opening of the injection gate 81 does not necessarily need to have the shape of a precise circle, but may also be a polygon or ellipse. However, the injection gate 81 is preferably formed so as to have a cross-sectional area that corresponds to an opening area of a circle whose diameter is in the range from 1.0 mm to 3.0 mm.

It is also possible to adopt, as the thin resin-filled structure of the film gate member, a configuration in which the injection gate 81 has, on at least one side thereof, a wall or groove shape. Adopting such a configuration increases the surface area that is adhered to the filling resin, further improving sealing property. A detailed example of such a configuration (for example, the shape of a projection or a recess) will be described later. Furthermore, as another example, a configuration in which a wall or a groove is formed on at least one side of the gate so as to improve the adhesiveness to the filling resin will be described in detail later.

Furthermore, it is also possible that an external connection member such as a cable or a connector is formed in one piece with the film gate member.

According to the present embodiment, when a resin having a high linear expansion coefficient (90×10⁻⁶/°C to 400×10⁻⁶/°C) is used to perform sealing, the total volume of the filling resin in the opening (for example, the injection gate) that is in communication with the outside is reduced as much as possible, thereby suppressing running-out of the filling resin from the opening due to thermal expansion of the resin. Here, this is realized by optimizing the thickness of the resin with which the section in the surrounding of the opening is filled. As described above, by designing the thickness of the resin to be in the range from 0.2 mm to 1.0 mm, more stress due to resin expansion occurs in the longitudinal direction than in the thickness direction (that is, the relationship "stress in longitudinal direction > stress in thickness direction" is satisfied). With this, resin expansion stress occurring when the device is used under a high-temperature environment (for example, 50°C or lower) can be absorbed in the longitudinal direction, that is, into the sealing resin.

Hereinafter, some film gate members that include the filling resin confining surface according to the present embodiment will be described.

### [Embodiment 1]

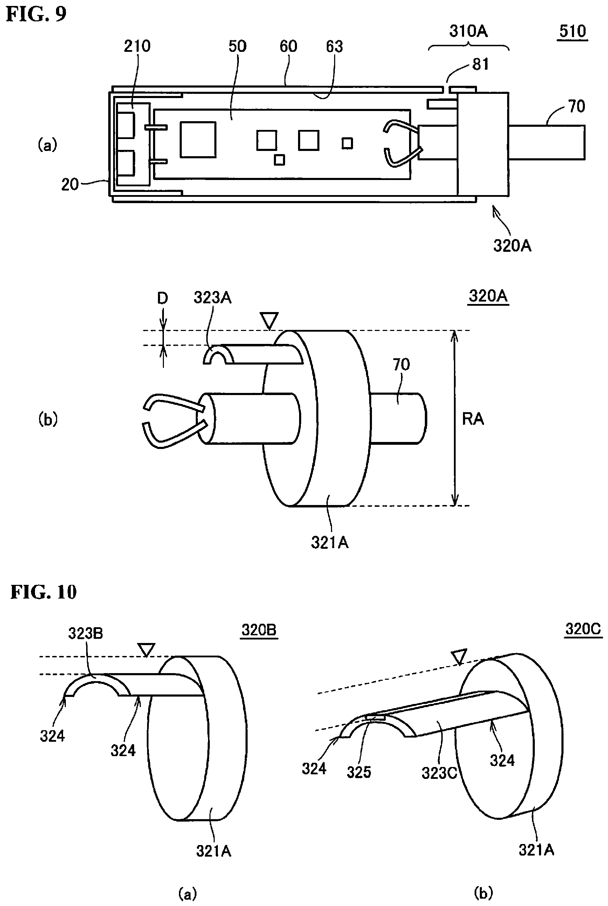

A film gate member according to Embodiment 1 will be described with reference to FIG. 9. FIG. 9 shows schematic diagrams illustrating a film gate member 320A and a proximity sensor including the film gate member 320A, according to Embodiment 1.

As shown in FIG. 9(a), in the proximity sensor 510 of Embodiment 1, the front end side of the base metal fitting 60, serving as the housing, is closed by the coil case 20 and the rear end side thereof is closed by a cylindrical case 310A that includes the film gate member 320A. The cylindrical case 310A including the film gate member 320A functions as a closing member for closing the base metal fitting 60. The cylindrical case 310A includes the ring cord 70, which is an external connection member. The cylindrical case 310A includes the injection gate 81. When the proximity sensor 510 is manufactured, a resin is injected into the cylindrical case 310A through the injection gate 81.

As shown in FIG. 9(b), the cylindrical case 310A of Embodiment 1 includes a first cylindrical section 321A, which is a main part and whose outer circumferential surface is configured to be in contact with the inner surface 63 of the base metal fitting 60 (casing), and a film gate section 323A that is formed in one piece with the first cylindrical section 321A.

The surface of the film gate section 323A on the injection gate 81 side corresponds to the filling resin confining surface. The filling resin confining surface of Embodiment 1 is formed in one piece with the first cylindrical section 321A (main part), and arranged at a position opposite to the injection gate 81. Furthermore, the area of the film gate section 323A on the injection gate 81 side is at least four times larger than the cross-sectional area of the injection gate 81.

The film gate section 323A has an arc-shaped structure so as to improve the flowability of a resin during filling. The outer surface (filling resin confining surface) of the film gate section 323A is arc-shaped such that the surface opposite to the injection gate 81 is convex when viewed in the cross section in the direction that is orthogonal to the axial direction of the central axis 102.

The following shows the results of evaluation about the resin running-out suppression effect and the fillability with resin, the results being obtained while varying a distance (thickness D of the section filled with a resin that is shown in FIG. 9(b)) between the film gate section 323A and the inner surface 63 of the base metal fitting 60. These evaluation results were obtained using a hot melt resin having a linear expansion coefficient of 280×10⁻⁶/°C as the sealing resin. The results obtained when the electronic device is subjected to a high-temperature environment (50°C) are evaluated.

The resin running-out suppression effect is visually evaluated using a digital fine scope. Since it is considered that the loss of a run-out resin does not occur when the amount of the run-out resin is less than 0.5 mm, the evaluation standard is set to 0.5 mm. That is, when the amount of the run-out resin is less than 0.5 mm, the suppression effect is judged to be "Good" (indicated with "A" in the following table), and when the amount of the run-out resin is 0.5 mm or more, the suppression effect is judged to be "Not Good" (indicated with "B" in the following table).

The fillability with resin is visually evaluated as to whether or not there is a section that is not filled with a resin between the film gate section 323A and the inner surface 63 of the base metal fitting 60 (thin resin-filled structure). That is, when the space is completely filled with a resin, the fillability with resin is judged to be "Good" (indicated with "A" in the following table), and when a part that is not filled with a resin remain in the space, the fillability with resin is judged to be "Not Good" (indicated with "B" in the following table).

The results that will be described below as well show that an appropriate distance (thickness D of the section filled with a resin) between the outer surface (filling resin confining surface) of the film gate section 323A and the inner surface 63 of the base metal fitting 60 is in the range from 0.2 mm to 1.0 mm.

In Examples 1 to 4 and Comparative Examples 1 and 2 shown in the table below, a distance (thickness D of the section filled with a resin) to the inner surface 63 of the base metal fitting 60 is varied in the range from 0.1 mm to 1.1 mm.

As shown in the table below, in the case where the thickness D of the section filled with a resin is 0.1 mm (Comparative Example 1), the required fillability with resin could not be obtained. More specifically, in Comparative Example 1, in which the thickness D of the section filled with a resin is 0.1 mm, a flow path through which a resin is injected from the injection gate 81 to the inside of the base metal fitting 60 could not be ensured sufficiently, resulting in that there is a section that is not filled with a resin. Note that since, in Comparative Example 1, there is a section that is not filled with a resin, the resin running-out suppression effect was not evaluated.

Furthermore, in the case where the thickness D of the section filled with a resin is 1.1 mm (Comparative Example 2), the required resin running-out suppression effect was not obtained. More specifically, running-out of the resin by about 0.4 to 0.8 mm occurred although there were individual differences, and in some cases, the amount of the run-out resin exceeded the evaluation standard of 0.5 mm.

In contrast thereto, it is clear that all Examples 1 to 4, in which the thickness D of the section filled with a resin is in the range from 0.2 mm to 1.0 mm, satisfy both requirements of the resin running-out suppression effect and the fillability with resin. Note that the case where the thickness D of the section filled with a resin is 0.2 mm (Example 1) shows the lower limit needed for ensuring the fillability with resin, and the case where the thickness D of the section filled with a resin is 1.0 mm (Example 4) shows the upper limit for exerting the resin running-out suppression effect.

**[Table 1]**

| | Comp. Ex. 1 | Ex. 1 | Ex. 2 | Ex. 3 | Ex. 4 | Comp. Ex. 2 |
|---|---|---|---|---|---|---|
| Thickness of section filled with resin (mm) | 0.1 | 0.2 (Lower limit) | 0.3 | 0.9 | 1.0 (Upper limit) | 1.1 |
| Evaluation of resin running-out (mm) | - | A <0.1 | A <0.1 | A 0.2-0.3 | A 0.2-0.4 | B 0.4-0.8 |
| Evaluation of fillability with resin | B | A | A | A | A | A |

Hereinafter, some modifications of Embodiment 1 will be described.

### [Modification 1 of Embodiment 1]

First, film gate members including an arc-shaped film gate section will be described with reference to FIG. 10. FIG. 10 shows schematic diagrams illustrating film gate members 320B and 320C according to Modification 1 of Embodiment 1.

In contrast to the film gate member 320A of Embodiment 1 shown in FIG. 9(b), the film gate member 320B shown in FIG. 10(a) is configured such that both sides 324 with respect to the longitudinal direction of the film gate section 323A are in contact with the inner surface 63 (not shown) of the base metal fitting 60. That is, the film gate member 320B includes a film gate section 323B that corresponds to a member that extends in an axial direction of the base metal fitting 60 (casing), and both sides 324 of the film gate section 323B are configured to be in contact with the inner surface 63 of the base metal fitting 60 (casing) over a predetermined length range in parallel to the axial direction of the central axis 102 of the base metal fitting 60 (casing).

By eliminating the gap between the film gate section 323A and the inner surface 63 of the base metal fitting 60 in this way, it is possible to separate a space in the vicinity of the injection gate 81 from another space using the film gate section 323B, mitigating the influence of running-out of the resin from the vicinity due to resin expansion.

The film gate member 320C shown in FIG. 10(b) includes, in addition to the film gate member 320B shown in FIG. 10(a), a flow path for guiding a resin to be injected. More specifically, a groove section 325 that extends in the longitudinal direction is formed on an outer surface of a film gate section 323C of the film gate member 320C. That is, the outer surface (filling resin confining surface) of the film gate section 323C has, on a surface thereof that is opposite to the injection gate 81, the groove section 325 extending in the axial direction of the central axis 102 of the base metal fitting 60 (casing). By providing such a groove section for guiding a resin in the axial direction of the central axis 102, it is possible to increase the surface area of the resin that is adhered to the film gate member 320C, further improving the sealing property.

The outer surfaces (filling resin confining surfaces) of the film gate section 323B shown in FIG. 10(a) and the film gate section 323C shown in FIG. 10(b) are arc-shaped such that the surfaces that are opposite to the injection gate 81 are convex when viewed in the cross sections in the direction that is orthogonal to the axial direction of the central axis 102. By adopting such a structure, it is possible to enhance the flowability of the resin during filling and to improve the fillability with resin.

### [Modification 2 of Embodiment 1]

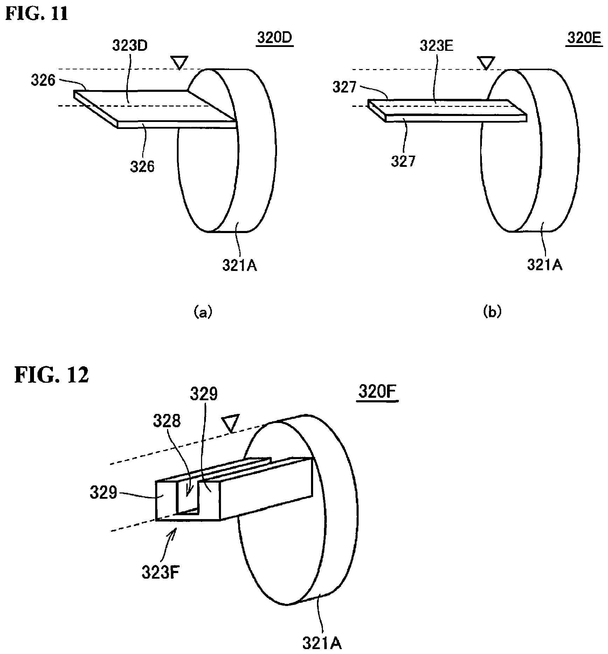

The following will describe a film gate member including a planar film gate section with reference to FIG. 11. FIG. 11 shows schematic diagrams illustrating film gate members 320D and 320E according to Modification 2 of Embodiment 1.

The film gate member 320D shown in FIG. 11(a) includes a non-arc-shaped film gate section 323D. More specifically, a planar member is used as the film gate section 323D. It is configured such that both sides 326 with respect to the longitudinal direction of the film gate section 323D are in contact with the inner surface 63 (not shown) of the base metal fitting 60. That is, the film gate member 320D includes the film gate section 323D that corresponds to a member extending in the axial direction of the base metal fitting 60 (casing), and both sides 326 of the film gate section 323D are configured to be in contact with the inner surface 63 of the base metal fitting 60 (casing) over a predetermined length range in parallel to the axial direction of the central axis 102 of the base metal fitting 60 (casing).

By eliminating a gap between the film gate section 323D and the inner surface 63 of the metal fitting 60 in this way, it is possible to separate a space in the vicinity of the injection gate 81 from another space using the film gate section 323D, mitigating the influence of running-out of the resin from the vicinity due to resin expansion.

On the other hand, the film gate member 320E shown in FIG. 11(b) also includes a non-arc-shaped film gate section 323E. The film gate member 320E corresponds to one that has a film gate section whose width is reduced relative to that of the film gate member 320D shown in FIG. 11(a). That is, the film gate member 320E includes the film gate section 323E, which corresponds to a member extending in the axial direction of the base metal fitting 60 (casing), and there are gaps to some extent between both sides 327 of the film gate section 323E and the inner surface 63 (not shown) of the base metal fitting 60. By such gaps remaining, it is possible to enhance the flowability of the resin during filling, and to improve the fillability with resin.

Both the outer surfaces (filling resin confining surfaces) of the film gate section 323D shown in FIG. 11(a) and the film gate section 323E shown in FIG. 11(b) are such that the surfaces opposite to the injection gate 81 have a planar cross sectional shape. By adopting such a relatively simple structure, it is possible to improve the yield of the film gate member.

### [Modification 3 of Embodiment 1]

The following will describe a film gate member including a film gate section that is planar and has a groove section with reference to FIG. 12. FIG. 12 is a schematic diagram illustrating a film gate member 320F according to Modification 3 of Embodiment 1.

The film gate member 320F shown in FIG. 12 includes a non-arc-shaped film gate section 323F. The outer surface of the film gate section 323F is provided with a groove section 328 that serves as a flow path for guiding a resin to be injected and extends in the longitudinal direction. More specifically, a pair of higher wall sections 329 is provided on two sides of the groove section 328 so as to extend in the longitudinal direction, and configure the groove section 328. That is, the outer surface (filling resin confining surface) of the film gate section 323F is such that the surface opposite to the injection gate 81 is provided with the wall sections 329 in the axial direction of the central axis 102 of the base metal fitting 60 (casing). By providing such a groove section for guiding a resin in the axial direction of the central axis 102, it is possible to increase the surface area of the resin that is adhered to the film gate member 320F, further improving the sealing property.

Furthermore, the outer surface (filling resin confining surface) of the film gate section 323F is such that the surfaces that are opposite to the injection gate 81 have a planar cross-sectional shape, and by adopting such a relatively simple structure, it is possible to improve the yield of film gate member.

### [Embodiment 2]

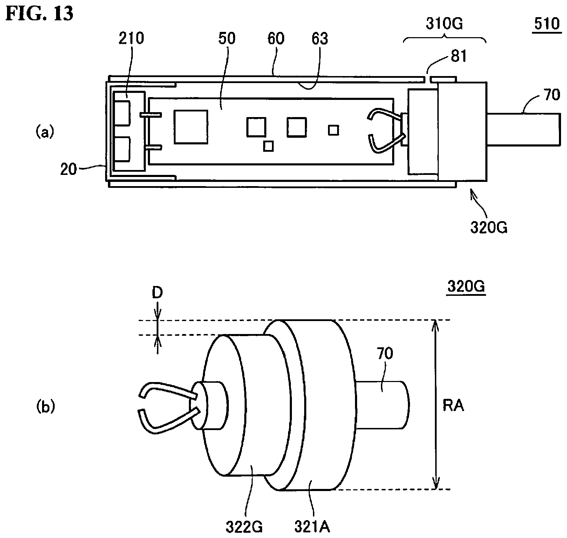

A film gate member according to Embodiment 2 will be described with reference to FIG. 13. FIG. 13 shows schematic diagrams illustrating a film gate member 320G and a proximity sensor including the film gate member 320G, according to Embodiment 2.

As shown in FIG. 13(a), in the proximity sensor 510 of Embodiment 2, the front end side of the base metal fitting 60, which serves as a housing, is closed by the coil case 20 and the rear end side thereof is closed by a cylindrical case 310G that includes the film gate member 320G. The cylindrical case 310G includes the ring cord 70, which is an external connection member. When the proximity sensor 510 is manufactured, a resin is injected into the cylindrical case 310G through the injection gate 81 formed in the cylindrical case 310G.

As shown in FIG. 13(b), the film gate member 320G of Embodiment 2 has, as an example, a sealing step structure. Specifically, the film gate member 320G has a configuration in which the first cylindrical section 321A that has a larger cross-sectional area (cross sectional radius) when viewed in the cross section in the direction that is orthogonal to the axial direction of the central axis 102, and a second cylindrical section 322G that has a smaller cross-sectional area (cross sectional radius) than that of the first cylindrical section 321A are adjacent and connected to each other. The outer surface of the first cylindrical section 321A is in contact with the inner surface 63 of the base metal fitting 60 (casing). The entire circumferential surface of the second cylindrical section 322G functions as a film gate section. That is, the entire circumferential surface of the second cylindrical section 322G may serve as a filling resin confining surface. Accordingly, the second cylindrical section 322G and the injection gate 81 need only be aligned in the axial direction of the central axis 102, without taking its position in the rotational direction into consideration.

The length in the axial direction (axial direction width) of the second cylindrical section 322G is determined so as to ensure an area of at least four times the cross-sectional area of the injection gate 81.

Accordingly, the cylindrical case 310G, which serves as a closing member, includes the first cylindrical section 321A (first section) whose outer surface is configured to be in contact with the inner surface 63 of the base metal fitting 60 (casing), and the second cylindrical section 322G (second section) that is formed in one piece with the first cylindrical section 321A and has a shape that is smaller than that of the first cylindrical section 321A when viewed in the cross section in the direction that is orthogonal to the axial direction of the central axis 102. Here, the filling resin confining surface is included in the second cylindrical section 322G (second section).

The following shows the results of evaluation about the resin running-out suppression effect and the fillability with resin, the results being obtained while varying a distance (thickness D of the section filled with a resin that is shown in FIG. 13(b)) between the outer surface (filling resin confining surface) of the second cylindrical section 322G and the inner surface 63 of the base metal fitting 60. These evaluation results were obtained by the same method as that of the foregoing Embodiment 1. Therefore, a detailed description of the method for evaluating the resin running-out suppression effect and the fillability with resin is not repeated.

The results below as well show that an appropriate distance (thickness D of the section filled with a resin) between the outer surface (filling resin confining surface) of the second cylindrical section 322G and the inner surface 63 of the base metal fitting 60 is in the range from 0.2 mm to 1.0 mm.

In Examples 5 to 8 and Comparative Examples 3 and 4 shown in the table below, a distance (thickness D of the section filled with a resin) between the outer surface of the second cylindrical section 322G and the inner surface 63 of the base metal fitting 60 is varied in the range from 0.1 mm to 1.1 mm.

As shown in the table below, in the case where the thickness D of the section filled with a resin is 0.1 mm (Comparative Example 3), the required fillability with resin could not be obtained. More specifically, in Comparative Example 3, in which the thickness D of the section filled with a resin is 0.1 mm, a flow path through which a resin is injected from the injection gate 81 to the inside of the base metal fitting 60 could not be ensured sufficiently, resulting in that there is a section that is not filled with a resin. Note that since, in Comparative Example 3, there is a section that is not filled with a resin, the resin running-out suppression effect was not evaluated.

Furthermore, in the case where the thickness D of the section filled with a resin is 1.1 mm (Comparative Example 4), the required resin running-out suppression effect was not obtained. More specifically, running-out of the resin by about 0.4 to 0.7 mm occurred although there were individual differences, and in some cases, the amount of the run-out resin exceeded the evaluation standard of 0.5 mm.

In contrast thereto, it is clear that all Examples 5 to 8, in which the thickness D of the section filled with a resin is in the range from 0.2 mm to 1.0 mm, satisfy both requirements of the resin running-out suppression effect and the fillability with resin. Note that the case where the thickness D of the section filled with a resin is 0.2 mm (Example 5) shows the lower limit needed for ensuring the fillability with resin, and the case where the thickness D of the section filled with a resin is 1.0 mm (Example 8) shows the upper limit for exerting the resin running-out suppression effect.

**[Table 2]**

| | Comp. Ex. 3 | Ex. 5 | Ex. 6 | Ex. 7 | Ex. 8 | Comp. Ex. 4 |
|---|---|---|---|---|---|---|
| Thickness of section filled with resin (mm) | 0.1 | 0.2 (Lower limit) | 0.3 | 0.9 | 1.0 (Upper limit) | 1.1 |
| Evaluation of resin running-out (mm) | - | A <0.1 | A <0.1 | A 0.1-0.2 | A 0.1-0.3 | B 0.4-0.7 |
| Evaluation of fillability with resin | B | A | A | A | A | A |

### [Embodiment 3]

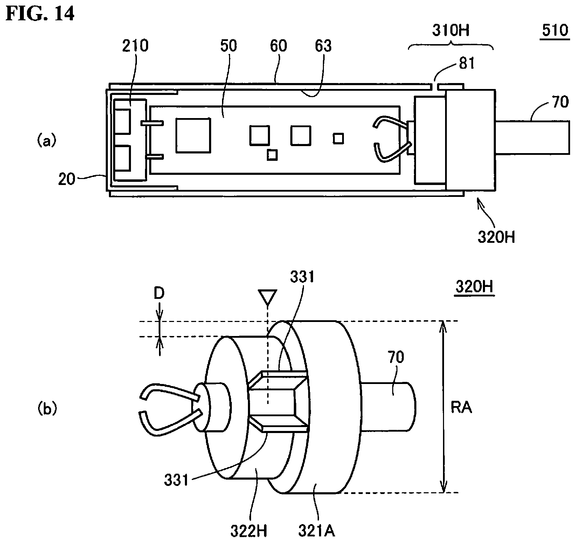

A film gate member according to Embodiment 3 will be described with reference to FIG. 14. FIG. 14 shows schematic diagrams illustrating a film gate member 320H and a proximity sensor including the film gate member 320H, according to Embodiment 3. In contrast to the film gate member 320G of Embodiment 2, the film gate member 320H of Embodiment 3 is further provided with a flow path for guiding filling with a resin.

As shown in FIG. 14(a), in the proximity sensor 510 of Embodiment 3, the front end side of the base metal fitting 60, serving as the housing, is closed by the coil case 20, and the rear end side thereof is closed by a cylindrical case 310H that includes the film gate member 320H. The cylindrical case 310H includes the ring cord 70, which is an external connection member. When the proximity sensor 510 is manufactured, a resin is injected into the cylindrical case 310H through the injection gate 81 formed in the cylindrical case 310H.

As shown in FIG. 14(b), the film gate member 320H of Embodiment 3 has a configuration in which the first cylindrical section 321A that has a larger cross-sectional area (cross sectional radius) when viewed in the cross section in the direction that is orthogonal to the axial direction of the central axis 102, and a second cylindrical section 322H that has a smaller cross-sectional area (cross sectional radius) than that of the first cylindrical section 321A are adjacent and connected to each other. The outer surface of the first cylindrical section 321A is in contact with the inner surface 63 of the base metal fitting 60 (casing). On the surface of the second cylindrical section 322H, a pair of regulatory plates (baffles) 331 is arranged so as to form a groove section that extends in the longitudinal direction. The outer circumferences of the pair of regulatory plates 331 are in contact with the inner surface 63 of the base metal fitting 60. That is, the outer surface (filling resin confining surface) of the second cylindrical section 322H has, on a surface opposite to the injection gate 81, a groove section extending in the axial direction of the central axis 102 of the base metal fitting 60 (casing).

The injection gate 81 is positioned such that the opposite position corresponds to a range enclosed by the pair of regulatory plates 331. That is, the pair of regulatory plates 331 forms, on the surface opposite to the injection gate 81, a groove section 325 extending in the axial direction of the central axis 102 of the base metal fitting 60 (casing). The length in the axial direction (axial direction width) of the second cylindrical section 322H and the width between the pair of regulatory plates 331 are determined so as to ensure an area of at least four times the cross-sectional area of the injection gate 81.

Accordingly, the cylindrical case 310H, which serves as a closing member, includes the first cylindrical section 321A (first section) whose outer surface is configured to be in contact with the inner surface 63 of the base metal fitting 60 (casing), and a second cylindrical section 322H (second section) that is formed in one piece with the first cylindrical section 321A and has a smaller shape than that of the first cylindrical section 321A when viewed in the cross section in the direction that is orthogonal to of the axial direction of the central axis 102. Here, the filling resin confining surface includes the second cylindrical section 322H (second section). By providing such a groove section for guiding a resin in the axial direction of the central axis 102, it is possible to increase the surface area of the resin that is adhered to the film gate member 320H, further improving the sealing property.

The following shows the results of evaluation about the resin running-out suppression effect and the fillability with resin, the results being obtained while varying a distance (thickness D of the section filled with a resin that is shown in FIG. 14(b)) between the outer surface (filling resin confining surface) of the second cylindrical section 322H and the inner surface 63 of the base metal fitting 60. These evaluation results were obtained by the same method as that of the foregoing Embodiment 1. Therefore, a detailed description of the method for evaluating the resin running-out suppression effect and the fillability with resin is not repeated.

The results below as well show that an appropriate distance (thickness D of the section filled with a resin) between the outer surface (filling resin confining surface) of the second cylindrical section 322H and the inner surface 63 of the base metal fitting 60 is in the range from 0.2 mm to 1.0 mm.

In Examples 9 to 12 and Comparative Examples 5 and 6 shown in the table below, a distance (thickness D of the section filled with a resin) between the outer surface of the second cylindrical section 322H and the inner surface 63 of the base metal fitting 60 is varied in the range from 0.1 mm to 1.1 mm.

As shown in the table below, in the case where the thickness D of the section filled with a resin is 0.1 mm (Comparative Example 5), the required fillability with resin could not be obtained. More specifically, in Comparative Example 5, in which the thickness D of the section filled with a resin is 0.1 mm, a flow path through which a resin is injected from the injection gate 81 to the inside of the base metal fitting 60 could not be ensured sufficiently, resulting in that there is a section that is not filled with a resin. Note that since, in Comparative Example 5, there is a section that is not filled with a resin, the resin running-out suppression effect was not evaluated.

Furthermore, in the case where the thickness D of the section filled with a resin is 1.1 mm (Comparative Example 6), the required resin running-out suppression effect was not obtained. More specifically, running-out of the resin by about 0.3 to 0.6 mm occurred although there were individual differences, and in some cases, the amount of the run-out resin exceeded the evaluation standard of 0.5 mm.

In contrast thereto, it is clear that all Examples 9 to 12, in which the thickness D of the section filled with a resin is in the range from 0.2 mm to 1.0 mm, satisfy both requirements of the resin running-out suppression effect and the fillability with resin. Note that the case where the thickness D of the section filled with a resin is 0.2 mm (Example 9) shows the lower limit needed for ensuring the fillability with resin, and the case where the thickness D of the section filled with a resin is 1.0 mm (Example 12) shows the upper limit for exerting the resin running-out suppression effect.

**[Table 3]**

| | Comp. Ex. 5 | Ex. 9 | Ex. 10 | Ex. 11 | Ex. 12 | Comp. Ex. 6 |
|---|---|---|---|---|---|---|
| Thickness of section filled with resin (mm) | 0.1 | 0.2 (Lower limit) | 0.3 | 0.9 | 1.0 (Upper limit) | 1.1 |
| Evaluation of resin running-out (mm) | - | A <0.1 | A <0.1 | A <0.1 | A 0.1-0.3 | B 0.3-0.6 |
| Evaluation of fillability with resin | B | A | A | A | A | A |

### [Embodiment 4]

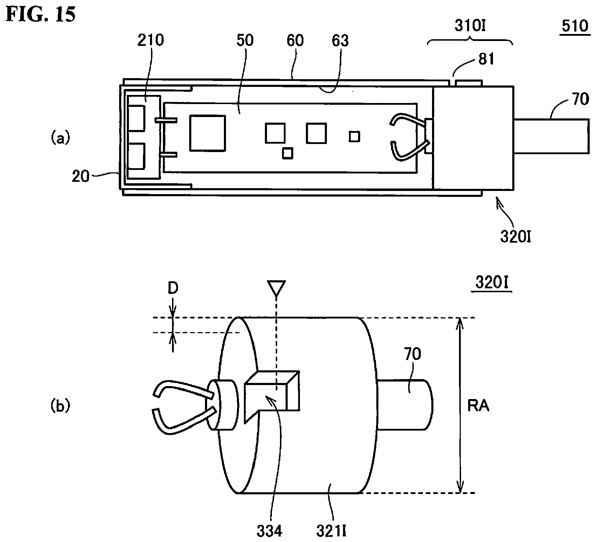

A film gate member according to Embodiment 4 will be described with reference to FIG. 15. FIG. 15 shows schematic diagrams illustrating a film gate member 3201 and a proximity sensor including the film gate member 320I, according to Embodiment 4.

As shown in FIG. 15(a), in the proximity sensor 510 of Embodiment 4, the front end side of the base metal fitting 60, which serves as a housing, is closed by the coil case 20, and the rear end side thereof is closed by a cylindrical case 310I that includes the film gate member 320I. The cylindrical case 310I includes the ring cord 70, which is an external connection member. When the proximity sensor 510 is manufactured, a resin is injected into the cylindrical case 310I through the injection gate 81 formed in the cylindrical case 310I.

As shown in FIG. 15(b), the film gate member 320I of Embodiment 4 includes a cylindrical first cylindrical section 321I, and the outer surface of the first cylindrical section 321I is in contact with the inner surface 63 of the base metal fitting 60 (casing). Furthermore, a cut-out section 334 is formed on a part of the outer surface of the first cylindrical section 321I. The cut-out section 334 functions as a film gate section. That is, an exposed surface of the cut-out section 334 may serve as the filling resin confining surface. The cut-out section 334 is positioned so as to correspond to the position of the injection gate 81. The length in the axial direction (axial direction width) and the width (circumferential direction width) of the cut-out section 334 are determined so as to ensure an area of at least four times the cross-sectional area of the injection gate 81.

Furthermore, a distance (thickness D of the section filled with a resin in the cut-out section 334) between the outer surface (filling resin confining surface) of the cut-out section 334 and the inner surface 63 of the base metal fitting 60 is designed to be in the range from 0.2 mm to 1.0 mm.

Accordingly, the cylindrical case 310I, which functions as a closing member, includes the first cylindrical section 321I (main part) whose outer surface is configured to be in contact with the inner surface 63 of the base metal fitting 60 (casing). Furthermore, the first cylindrical section 321I has the cut-out section 334 that has a distance between the outer surface thereof and the inner surface 63 of the base metal fitting 60 (casing) in the range from 0.2 mm to 1.0 mm. The cut-out section 334 of the cylindrical case 3101 is arranged so as to communicate with the injection gate 81. According to the cylindrical case 310I of Embodiment 4, since the relatively simple structure in which the first cylindrical section 321I, serving as the main part, is partially cut out is adopted, it is possible to improve the yield of the film gate member.

The following shows the results of evaluation about the resin running-out suppression effect and the fillability with resin, the results being obtained while varying a distance (thickness D of the section filled with a resin of the cut-out section 334 that is shown in FIG. 15(b)) between the outer surface (filling resin confining surface) of the cut-out section 334 and the inner surface 63 of the base metal fitting 60. These evaluation results were obtained by the same method as that of the foregoing Embodiment 1. Therefore, a detailed description of the method for evaluating the resin running-out suppression effect and the fillability with resin is not repeated.

The results below as well show that an appropriate distance (thickness D of the section filled with a resin) between the outer surface (filling resin confining surface) of the cut-out section 334 and the inner surface 63 of the base metal fitting 60 is in the range from 0.2 mm to 1.0 mm.

In Examples 13 to 16 and Comparative Examples 7 and 8 shown in the table below, a distance (thickness D of the section filled with a resin) between the outer surface of the cut-out section 334 and the inner surface 63 of the base metal fitting 60 is varied in the range from 0.1 mm to 1.1 mm.

As shown in the table below, in the case where the thickness D of the section filled with a resin is 0.1 mm (Comparative Example 7), the required fillability with resin could not be obtained. More specifically, in Comparative Example 7, in which the thickness D of the section filled with a resin is 0.1 mm, a flow path through which a resin is injected from the injection gate 81 to the inside of the base metal fitting 60 could not be ensured sufficiently, resulting in that there is a section that is not filled with a resin. Note that since, in Comparative Example 7, there is a section that is not filled with a resin, the resin running-out suppression effect was not evaluated.

Furthermore, in the case where the thickness D of the section filled with a resin is 1.1 mm (Comparative Example 8), the required resin running-out suppression effect was not obtained. More specifically, running-out of the resin by about 0.3 to 0.6 mm occurred although there were individual differences, and in some cases, the amount of the run-out resin exceeded the evaluation standard of 0.5 mm.

In contrast thereto, it is clear that all Examples 13 to 16, in which the thickness D of the section filled with a resin is in the range from 0.2 mm to 1.0 mm, satisfy both requirements of the resin running-out suppression effect and the fillability with resin. Note that the case where the thickness D of the section filled with a resin is 0.2 mm (Example 13) shows the lower limit needed for ensuring the fillability with resin, and the case where the thickness D of the section filled with a resin is 1.0 mm (Example 16) shows the upper limit for exerting the resin running-out suppression effect.

**[Table 4]**

| | Comp. Ex. 7 | Ex. 13 | Ex. 14 | Ex. 15 | Ex. 16 | Comp. Ex. 8 |
|---|---|---|---|---|---|---|
| Thickness of section filled with resin (mm) | 0.1 | 0.2 (Lower limit) | 0.3 | 0.9 | 1.0 (Upper limit) | 1.1 |
| Evaluation of resin running-out (mm) | - | A <0.1 | A <0.1 | A <0.1 | A 0.1-0.3 | B 0.3-0.6 |
| Evaluation of fillability with resin | B | A | A | A | A | A |

### [Embodiment 5]

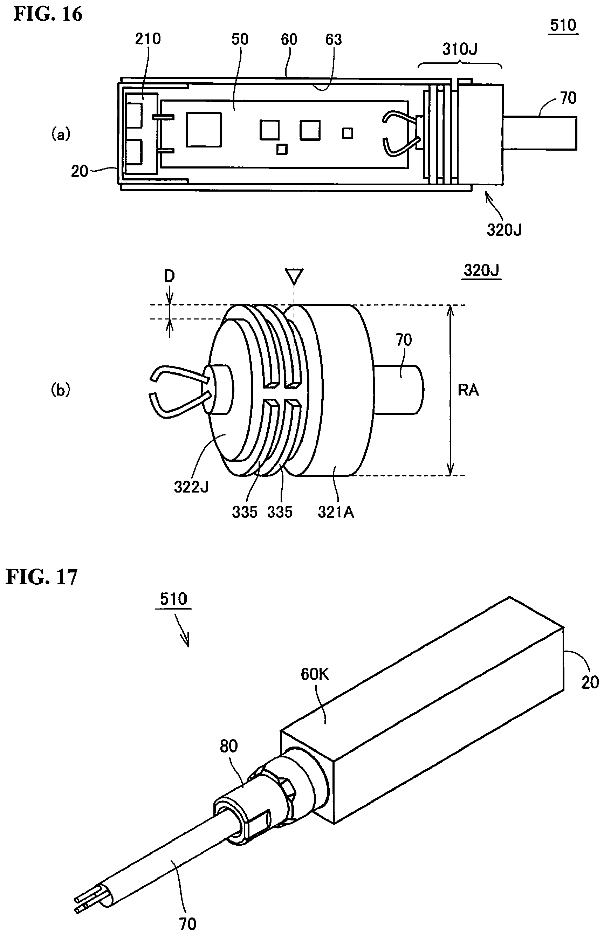

A film gate member according to Embodiment 5 will be described with reference to FIG. 16. FIG. 16 shows schematic diagrams illustrating a film gate member 320J and a proximity sensor including the film gate member 320J, according to Embodiment 5. In contrast to the film gate member 320G of Embodiment 2, the film gate member 320J of Embodiment 5 further includes a flow path for guiding filling with a resin.

As shown in FIG. 16(a), in the proximity sensor 510 of Embodiment 5, the front end side of the base metal fitting 60, which serves as a housing, is closed by the coil case 20, and the rear end side thereof is closed by a cylindrical case 310J that includes the film gate member 320J. The cylindrical case 310J includes the ring cord 70, which is an external connection member. When the proximity sensor 510 is manufactured, a resin is injected into the cylindrical case 310J through the injection gate 81 formed in the cylindrical case 310J.

As shown in FIG. 16(b), the film gate member 320J of Embodiment 5 has a configuration in which the first cylindrical section 321A that has a larger cross-sectional area (cross sectional radius) when viewed in the cross section in the direction that is orthogonal to the axial direction of the central axis 102, and a second cylindrical section 322J that has a smaller cross-sectional area (cross sectional radius) than that of the first cylindrical section 321A are adjacent and connected to each other. The outer surface of the first cylindrical section 321A is in contact with the inner surface 63 of the base metal fitting 60 (casing). On the surface of the second cylindrical section 322J, one or more projections 335 (two lines of projections in the example shown in FIG. 16(b)) are provided so as to form a groove that extends in the circumferential direction. The outer circumferential side of each projection 335 is in contact with the inner surface 63 of the base metal fitting 60. That is, the outer surface in the circumferential direction of the second cylindrical section 322J (second section) has, on the side that is opposite to the inner surface of the base metal fitting 60 (casing), the projections 335 that extend in the circumferential direction.

The injection gate 81 is positioned such that the opposite position corresponds to a range enclosed by projections 335. The filling resin confining surface corresponds to the outer surface of the second cylindrical section 322J (second section). The length in the axial direction (axial direction width) of the second cylindrical section 322J and the number and the length (axial direction width) in the axial direction of the projections 335 are determined so as to ensure an area of at least four times the cross-sectional area of the injection gate 81. By providing a groove section for guiding a resin that constitutes the length in the axial direction (axial direction width), it is possible to increase the surface area of the resin that is adhered to the film gate member 320J, further improving the sealing property.

The following shows the results of evaluation of the resin running-out suppression effect and the fillability with resin, the results being obtained while varying a distance (thickness D of the section filled with a resin that is shown in FIG. 16(b)) between the outer surface (filling resin confining surface) of the second cylindrical section 322J and the inner surface 63 of the base metal fitting 60. These evaluation results were obtained by the same method as that of the foregoing Embodiment 1. Therefore, a detailed description of the method for evaluating the resin running-out suppression effect and the fillability with resin is not repeated.

The results below as well show that an appropriate distance (thickness D of the section filled with a resin) between the outer surface (filling resin confining surface) of the second cylindrical section 322J and the inner surface 63 of the base metal fitting 60 is in the range from 0.2 mm to 1.0 mm.

In Examples 17 to 20 and Comparative Examples 9 and 10 shown in the table below, a distance (thickness D of the section filled with a resin) between the outer surface of the second cylindrical section 322J and the inner surface 63 of the base metal fitting 60 is varied in the range from 0.1 mm to 1.1 mm.

As shown in the table below, in the case where the thickness D of the section filled with a resin is 0.1 mm (Comparative Example 9), the required fillability with resin could not be obtained. More specifically, in Comparative Example 9, in which the thickness D of the section filled with a resin is 0.1 mm, a flow path through which a resin is injected from the injection gate 81 to the inside of the base metal fitting 60 could not be ensured sufficiently, resulting in that there is a section that is not filled with a resin. Note that since, in Comparative Example 9, there is a section that is not filled with a resin, the resin running-out suppression effect was not evaluated.

Furthermore, in the case where the thickness D of the section filled with a resin is 1.1 mm (Comparative Example 10), the required resin running-out suppression effect was not obtained. More specifically, running-out of the resin by about 0.3 to 0.6 mm occurred although there were individual differences, and in some cases, the amount of the run-out resin exceeded the evaluation standard of 0.5 mm.

In contrast thereto, it is clear that all Examples 17 to 20, in which the thickness D of the section filled with a resin is in the range from 0.2 mm to 1.0 mm, satisfy both requirements of the resin running-out suppression effect and the fillability with resin. Note that the case where the thickness D of the section filled with a resin is 0.2 mm (Example 17) shows the lower limit needed for ensuring the fillability with resin, and the case where the thickness D of the section filled with a resin is 1.0 mm (Example 18) shows the upper limit for exerting the resin running-out suppression effect.

**[Table 5]**

| | Comp. Ex. 9 | Ex. 17 | Ex. 18 | Ex. 19 | Ex. 20 | Comp. Ex. 10 |
|---|---|---|---|---|---|---|
| Thickness of section filled with resin (mm) | 0.1 | 0.2 (Lower limit) | 0.3 | 0.9 | 1.0 (Upper limit) | 1.1 |
| Evaluation of resin running-out (mm) | - | A <0.1 | A <0.1 | A <0.1 | A 0.1-0.3 | B 0.3-0.6 |
| Evaluation of fillability with resin | B | A | A | A | A | A |

### [Embodiment 6]

Although the foregoing Embodiments 1 to 5 have shown configurations in which the base metal fitting 60 and the coil case 20 are cylindrical, the base metal fitting 60 and the coil case 20 may have any cross-sectional shape according to the present invention as long as they are tubular. For example, a tubular base metal fitting and a tubular coil case that have any polygonal cross-sectional shape may be used.

FIG. 17 is a perspective view illustrating a proximity sensor 510 of Embodiment 6. The proximity sensor 510 shown in FIG. 17 has an outer appearance extending in the shape of a quadrangular prism along the central axis. The proximity sensor 510 includes a detecting unit (not shown), the coil case 20, the printed board (not shown), a base metal fitting 60K, which serves as a housing, the clamp 80, and the ring cord 70. For such an electronic device including a quadrangular prism-shaped housing, a film gate member 320K formed according to that housing is used.

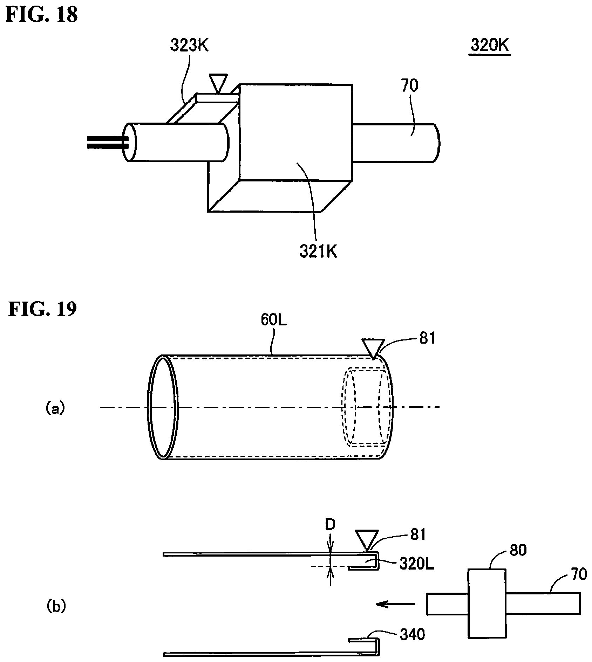

FIG. 18 is a schematic diagram illustrating the film gate member 320K of Embodiment 6. The film gate member 320K shown in FIG. 18 mainly includes a square tube 321K, which serves as a main part, and a film gate section 323K, which is formed in one piece with the square tube 321K. The film gate section 323K shown in FIG. 18 has a configuration similar to that of the film gate members 320D and 320E of Modification 2 of Embodiment 1 shown in FIG. 11. Therefore, descriptions of the filling resin confining surface and functional effects brought about by the filling resin confining surface are not repeated here. Furthermore, the technical ideas described with reference to the foregoing Embodiments 1 to 5 are also applicable in a similar fashion.

In other words, the technical ideas according to the present invention are applicable to a tubular housing whose cross-sectional shape is any of a circle, an ellipse, and a polygon, and the film gate member is designed appropriately according to the cross-sectional shape of the housing.

### [Embodiment 7]

Although the foregoing Embodiments 1 to 6 have described examples of configurations in which the film gate member is formed as a part of the closing member for closing an opening on the rear end side of the base metal fitting 60, which is a casing, the film gate member may be formed as a part of the casing, that is, both components may be integrated into one piece. The following will describe the configuration in which a film gate member is formed in one piece with the casing.

FIG. 19 shows schematic diagrams illustrating a film gate member and a proximity sensor including the film gate member, according to Embodiment 7. FIG. 19(a) is a perspective view of the proximity sensor of Embodiment 7, and FIG. 19(b) is a cross-sectional view of the proximity sensor of Embodiment 7.

As shown in FIGS. 19(a) and 19(b), the injection gate 81 is provided on the rear end side of a base metal fitting 60L of Embodiment 7, and a hollow structure 320L that is in communication with this injection gate 81 is formed. The hollow structure 320L guides a resin injected into the base metal fitting 60L through the injection gate 81 toward the inside of the base metal fitting 60L, and also serves as a filling resin confining surface for suppressing running-out of the resin due to thermal expansion of the resin section. That is, the hollow structure 320L serves as a film gate member.

The width in the radial direction of the hollow structure 320L (that is, the thickness D of the section filled with a resin) is designed to be in the range from 0.2 mm to 1.0 mm, and the area of the hollow structure 320L (the axial direction length x the circumferential direction width) is designed to be at least four times larger than the cross-sectional area of the injection gate 81. By using such design values, it is possible to realize the same effect as the above-described resin running-out suppression effect using the filling resin confining surface.

The clamp 80 to which the ring cord 70 is connected is configured to be fitted to the internal side of the position at which the hollow structure 320L of the base metal fitting 60L is provided, and the rear end side of the base metal fitting 60L is closed by the clamp 80 being fitted into, the clamp 80 and the ring cord 70 serving as a closing member. That is, a fitting section 340 on the rear end side of the base metal fitting 60L and the clamp 80 are fitted to each other.

In this way, the fitting section 340 into which the clamp 80 and the ring cord 70 (closing member) are fitted is provided on one end of the base metal fitting 60L (casing). The fitting section 340 is configured such that an inner surface thereof to which the clamp 80 and the ring cord 70 are fitted has a smaller cross-sectional shape in the direction that is orthogonal to the axial direction of the base metal fitting 60L (casing) than that of another section of the base metal fitting 60L (casing) and has the hollow structure 320L that is in communication with the inside of the base metal fitting 60L (casing). The injection gate 81 is provided close to the fitting section 340, and the thickness of the hollow structure 320L is configured to be in the range from 0.2 mm to 1.0 mm.

According to the present embodiment, the filling resin confining surface is formed on the base metal fitting 60L that is made typically from metal, and thus processing is simplified as compared with the closing member that is made typically from a resin. Therefore, it is possible to improve the yield of the entire device.

### [Embodiment 8]

Although the foregoing Embodiments 1 to 6 have described examples of configurations in which the film gate member is formed as a part of the closing member for closing an opening on the rear end side of the base metal fitting 60, which is a casing, the filling resin confining surface may be realized by both of the base metal fitting and the closing member. The following will describe the configuration in which a film gate member is formed in cooperation with the casing and the closing member.

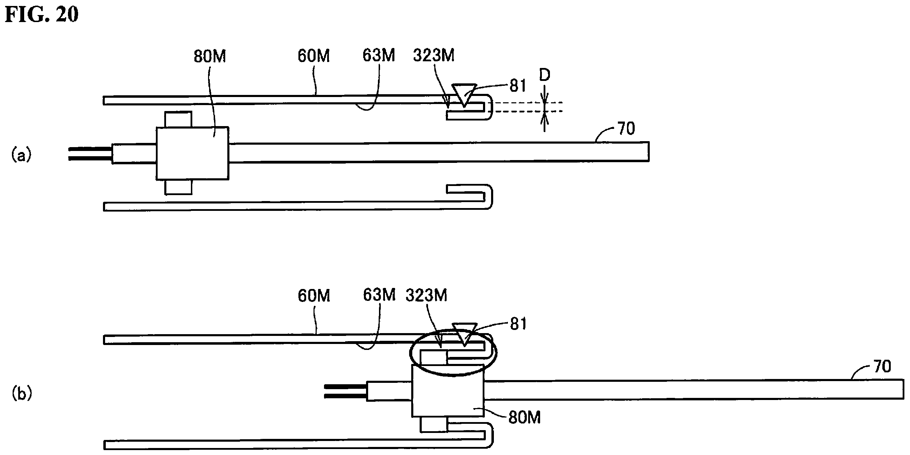

FIG. 20 shows schematic diagrams illustrating a film gate section according to Embodiment 8. FIGS. 20(a) and 20(b) show processes performed when a base metal fitting 60M that constitutes a proximity sensor according to Embodiment 8 is closed on its rear end side. That is, in Embodiment 8, a clamp 80M that is formed in one piece with the ring cord 70 is inserted into the base metal fitting 60M, serving as a housing, from the front end side and moved to the rear end side, and these components are fixed. The base metal fitting 60M has, on its rear end side, a fitting section 323M that has a shape in which the end of the base metal fitting 60M is bent inward, and the injection gate 81 is provided in the vicinity of the fitting section 323M. The injection gate 81 is in communication with the inside and outside of the base metal fitting 60M, which serves as the casing. The fitting section 323M has a hollow structure over the entire circumference of the base metal fitting 60M on the rear end side.

As shown in FIG. 20(b), in the state in which the clamp 80M is fixed to the rear end side of the base metal fitting 60M, the outer circumferential surface of the section (flange section) of the clamp 80M that has a larger circumference than that of other sections is continuous with the fitting section 323M, and a hollow space that is formed by the fitting section 323M is enlarged to the front end side in the axial direction. The internal surface of the enlarged hollow space corresponds to the filling resin confining surface.

That is, the fitting section 323M to which the clamp 80M (closing member) is fitted is provided on one end of the base metal fitting 60M, which serves as the casing. The fitting section 323M is configured such that an inner surface thereof to which the clamp 80M (closing member) is fitted has a smaller cross-sectional shape than that of another section of the base metal fitting 60M, and has a hollow structure that is in communication with the inside of the base metal fitting 60M. A resin that is to be injected through the injection gate 81 will pass through the hollow space formed by the fitting section 323M and the clamp 80M and fill up the internal space of the base metal fitting 60M on the left side of the drawing.

The clamp 80M (closing member) includes a main part that is in contact with the inner surface of the fitting section 323M, and the flange section (projection) whose outer surface is configured to be continuous with the internal surface of the hollow structure. A distance (thickness D of the section filled with a resin that is shown in FIG. 20(a)) between the fitting section 323M and the flange section of the clamp 80M, and the inner surface 63M of the base metal fitting 60M is designed to be in the range from 0.2 mm to 1.0 mm. That is, the thickness of the hollow structure is configured to be in the range from 0.2 mm to 1.0 mm. Furthermore, the area of the hollow space configured by the fitting section 323M and the clamp 80M is designed to be at least four times larger than the cross-sectional area of the injection gate 81.

The injection gate 81 is provided in the section that is opposite to the fitting section 323M or in the section that is opposite to the projection of the clamp 80M. That is, the injection gate 81 is arranged at a position that is close to the fitting section 323M and the clamp 80M on the rear end side of the base metal fitting 60M.

By using such design values, it is possible to realize the same effect as the above-described resin running-out suppression effect using the filling resin confining surface.

### [Advantages]

According to the present embodiment, by configuring the film gate section that realizes the filling resin confining surface, it is possible to suppress resin expansion in a thickness direction even when an electronic device is filled with a resin (e.g., a hot melt resin) whose linear expansion coefficient is at least 90×10⁻⁶/°C and at most 400×10⁻⁶/°C. Accordingly, even when this electronic device is used in a high-temperature environment, it is possible to significantly reduce the risk that the filling resin runs out from the gate due to thermal expansion of the resin.

Furthermore, according to the present embodiment, water resistance (sealing property) can be ensured by forming a thin resin-filled structure on one end of the casing and filling the thin resin-filled structure with a resin to provide a sealing structure over the entire circumference. Moreover, according to the present embodiment, since the sealing structure is filled with a resin in the first stage of resin injection, it is possible to ensure stable water resistance.

### [Other Embodiments]

The above-described embodiments have been described, taking the proximity sensor as an example of the electronic device, but the present invention is not limited to the proximity sensor. Typically, the present invention may be applicable to a photoelectric sensor, a fiber sensor, a smart sensor, or the like.

A photoelectric sensor detects presence or absence of an object, a change in a surface state, or the like, using various properties of light emitted from a light emission source. A detecting unit of the photoelectric sensor includes, as the light emission source, a light emitting diode, a semiconductor laser, or the like. A fiber sensor is a sensor in which an optical fiber is incorporated with a photoelectric sensor. A detecting unit of the fiber sensor as well includes, as the light emission source, a light emitting diode, a semiconductor laser, or the like. A smart sensor is a sensor that has, in added to functions of a proximity sensor or a photoelectric sensor, functions to perform analysis and information processing. In the case where a proximity sensor is used as a basic configuration of the smart sensor, a detecting unit corresponds to any one of the detecting units of the above-described embodiments, whereas in the case where a photoelectric sensor is used as a basic configuration of the smart sensor, a light emitting diode, a semiconductor laser, or the like is included as a light emission source.

Although the embodiments and examples according to the present invention have been described, the embodiments and examples disclosed here are, in every respect, exemplary and not restrictive. The technical scope of the present invention is defined by the claims, and the intention is to cover all modifications in the meaning and scope of equivalent to the claims.

### LIST OF REFERENCE NUMERALS

- 20: Coil case
- 30: Coil spool
- 36: Electromagnetic coil
- 37: End
- 40: Core
- 46: Coil pin
- 50: Printed board
- 60, 60K, 60L, 60M: Base metal fitting
- 61, 62, 82: Opening
- 63, 63M: Inner surface
- 70: Ring cord
- 71: Cable
- 72: Ring member
- 80, 80M: Clamp
- 81: Injection gate
- 102: Central axis
- 120: Resin section
- 210: Detecting unit
- 280: Linear expansion coefficient
- 310, 310A, 310G, 310H, 310I, 310J: Cylindrical case
- 320, 320A, 320B, 320C, 320D, 320E, 320F, 320G, 320H, 320I, 320J, 320K: Film gate member
- 320L: Hollow structure
- 321, 321A, 321I: First cylindrical section
- 321K: Square tube
- 322, 322G, 322H, 322J: Second cylindrical section
- 323, 323A, 323B, 323C, 323D, 323E, 323F, 323K: Film gate section
- 323M, 340: Fitting section
- 324, 326, 327: Both sides
- 325, 328: Groove section
- 329: Wall section
- 331: Regulatory plate
- 332: Gate surrounding section
- 334: Cut-out section
- 335: Projections
- 510: Proximity sensor
- D: Thickness of the section filled with a resin

## Claims

1. An electronic device (510) comprising:
a casing (60; 60K; 60L; 60M) that is tubular and whose one end is closed;
a closing member (70, 80; 80M) that closes an opening at the other end of the casing (60; 60K; 60L; 60M);
an electronic component that is arranged at a position enclosed by the casing (60; 60K; 60L; 60M) and the closing member (70, 80; 80M); and
a resin section (120) that fills up the inside of the casing (60; 60K; 60L; 60M) and has a linear expansion coefficient of at least 90×10⁻⁶/°C and at most 400×10⁻⁶/°C,
wherein the casing (60; 60K; 60L; 60M) is provided with a gate (81) for filling of the resin section (120), the gate (81) being in communication with the inside and outside of the casing (60; 60K; 60L; 60M), and
a filling resin confining surface is provided inside of the casing (60; 60K; 60L; 60M), the filling resin confining surface being at least partially arranged at a position opposite to the gate (81), and including a region that has a distance to an inner surface (63; 63M) of the casing (60; 60K; 60L; 60M) of at least 0.2 mm and at most 1.0 mm and that has an area of at least four times the cross-sectional area of the gate (81).

2. The electronic device (510) according to claim 1,
wherein the gate (81) has a cross-sectional area that corresponds to an opening area of a circle whose diameter is in a range from 1.0 mm to 3.0 mm.

3. The electronic device (510) according to claim 1 or 2,
wherein the closing member (70, 80) includes a main part (321; 321A; 321I) whose outer circumferential surface is configured to be in contact with an inner surface (63) of the casing (60), and
the filling resin confining surface is formed in one piece with the main part (321; 321A; 321I) and arranged at the position opposite to the gate (81).

4. The electronic device (510) according to any one of claims 1 to 3,
wherein the filling resin confining surface includes a member (323B; 323C; 323D) that extends in an axial direction of the casing (60), and both sides (324; 326) with respect to the extending direction of the member (323B; 323C; 323D) are configured to be in contact with the inner surface (63) of the casing (60) over a predetermined length range in parallel to the axial direction of the casing (60).

5. The electronic device (510) according to any one of claims 1 to 3,
wherein the filling resin confining surface includes a member (323A; 323E; 323F) that extends in the axial direction of the casing (60), and a gap is formed between the member (323A; 323E; 323F) and the inner surface (63) of the casing (60).

6. The electronic device (510) according to any one of claims 1 to 5,
wherein the filling resin confining surface has, on a surface thereof that is opposite to the gate (81), a groove section (325; 328) extending in the axial direction of the casing (60).

7. The electronic device (510) according to any one of claims 1 to 6,
wherein the filling resin confining surface is arc-shaped such that the surface opposite to the gate (81) is convex when viewed in a cross section in a direction that is orthogonal to the axial direction of the casing (60).

8. The electronic device (510) according to any one of claims 1 to 7,
wherein the closing member (70, 80) includes a first section (321; 321A; 321I) at least a part of whose outer circumferential surface is configured to be in contact with the inner surface (63) of the casing (60), and a second section (322; 322G; 322H; 322J) that is formed in one piece with the first section (321; 321A; 321I) and has a smaller shape than that of the first section (321; 321A; 321I) when viewed in the cross section in a direction that is orthogonal to the axial direction of the casing (60), and
the filling resin confining surface includes an outer circumferential surface of the second section (322; 322G; 322H; 322J).

9. The electronic device (510) according to any one of claims 1 to 8,
wherein the first section (321) has a cut-out section (323) that is configured to be continuous with the outer circumferential surface of the second section (322).

10. The electronic device (510) according to any one of claims 1 to 9,
wherein a pair of projections (331) that extends in the axial direction of the casing (60) is provided on the outer circumferential surface of the second section (322H), and
the closing member (70, 80) is arranged such that a space between the pair of projections (331) is in communication with the gate (81).

11. The electronic device (510) according to any one of claims 1 to 10,
wherein a projection (335) that extends in a circumferential direction is provided on the outer circumferential surface of the second section (322J) on the side that is opposite to the inner surface (63) of the casing (60).

12. The electronic device (510) according to any one of claims 1 to 11,
wherein the closing member (70, 80) includes a main part (321I) whose outer circumferential surface is configured to be in contact with the inner surface (63) of the casing (60),
the main part (321I) has a cut-out section (334) that is configured such that a distance between an outer surface of the cut-out section (334) and the inner surface (63) of the casing (60) is in a range from 0.2 mm to 1.0 mm, and
the closing member (70, 80) is arranged such that the cut-out section (334) is in communication with the gate (81).

13. The electronic device (510) according to any one of claims 1 to 12,
wherein the casing (60L) has, on one end thereof, a fitting section (340) to which the closing member (70, 80) is fitted,
the fitting section (340) is configured such that an inner surface thereof to which the closing member (70, 80) is fitted has a smaller cross-sectional shape in a direction that is orthogonal to the axial direction of the casing (60L) than that of another section of the casing (60L), and has a hollow structure that is in communication with the inside of the casing (60L), and
the gate (81) is provided close to the fitting section (340), and the thickness of the hollow structure is configured to be in a range from 0.2 mm to 1.0 mm.

14. The electronic device (510) according to any one of claims 1 to 13,
wherein the casing (60M) has, on one end thereof, a fitting section (323M) to which the closing member (70, 80M) is fitted,
the fitting section (323M) is configured such that an inner surface thereof to which the closing member (70, 80M) is fitted has a smaller cross-sectional shape than that of another section of the casing (60M), and has a hollow structure that is in communication with the inside of the casing (60M),
the thickness of the hollow structure is configured to be in a range from 0.2 mm to 1.0 mm,
the closing member (70, 80M) includes a main part that is in contact with the inner surface of the fitting section (323M), and a projection whose outer circumferential surface is continuous with the inner surface of the hollow structure, and
the gate (81) is provided in a section that is opposite to the fitting section (323M) or a section that is opposite to the projection of the closing member (70, 80M), and a surface that is opposite to the gate (81) serves as the filling resin confining surface.

15. An electronic device (510) comprising:
a casing (60L) that is tubular and whose one end is closed;
an electronic component that is arranged at a position enclosed by the casing (60L); and
a resin section (120) that fills up the inside of the casing (60L) and has a linear expansion coefficient of at least 90×10⁻⁶/°C and at most 400×10⁻⁶/°C,
wherein the casing (60L) has, on the other end thereof, a bent inward projection (340) whose inner surface has a smaller cross-sectional shape than that of another section of the casing (60L) and that has a hollow structure (320L) that is in communication with the inside of the casing (60L)
the casing (60L) is provided with a gate (81) for filling of the resin section (120), the gate (81) being in communication with the inside and outside of the casing (60L) and
the hollow structure (320L) of the projection (340) defines the thickness of the resin that is filled from the gate (81) into the hollow structure (320L) in a range from 0.2 mm to 1.0 mm.

16. The electronic device (510) according to any one of claims 1 to 15,
wherein an application temperature of the above-described electronic device is in a range from -30°C to 85°C.

## Patentansprüche

1. Elektronische Vorrichtung (510), umfassend:
eine Ummantelung (60; 60K; 60L; 60M), die rohrförmig ist und deren eines Ende geschlossen ist;
ein Verschlusselement (70, 80; 80M), das eine Öffnung an dem anderen Ende der Ummantelung (60; 60K; 60L; 60M) verschließt;
ein elektronisches Bauteil, das an einer durch die Ummantelung (60; 60K; 60L; 60M) und das Verschlusselement (70, 80; 80M) umschlossenen Position angeordnet ist; und
einen Harzabschnitt (120), der das Innere der Ummantelung (60; 60K; 60L; 60M) ausfüllt und einen Ausdehnungskoeffizienten vom mindestens 90×10⁻⁶/°C und höchstens 400×10⁻⁶/°C aufweist,
wobei die Ummantelung (60; 60K; 60L; 60M) mit einer Öffnung (81) zum Füllen des Harzabschnitts (120) versehen ist, wobei die Öffnung (81) mit dem Inneren und dem Äußeren der Ummantelung (60; 60K; 60L; 60M) in Verbindung steht, und
eine in der Ummantelung (60; 60K; 60L; 60M) vorgesehene Füllharzbegrenzungsfläche, wobei die Füllharzbegrenzungsfläche mindestens teilweise an einer der Öffnung (81) gegenüberliegenden Position angeordnet ist, und einen Bereich beinhaltet, der einen Abstand zu einer Innenfläche (63; 63M) der Ummantelung (60; 60K; 60L; 60M) von mindestens 0,2 mm und höchstens 1,0 mm aufweist, und eine Fläche vom mindestens dem vierfachen der Querschnittsfläche der Öffnung (81) aufweist.

2. Elektronische Vorrichtung (510) nach Anspruch 1,
wobei die Öffnung (81) eine Querschnittsfläche aufweist, die einer Öffnungsfläche eines Kreises entspricht, dessen Durchmesser im Bereich von 1,0 mm bis 3,0 mm liegt.

3. Elektronische Vorrichtung (510) nach Anspruch 1 oder 2,
wobei das Verschlusselement (70, 80) einen Grundkörper (321; 321A; 321I) beinhaltet, dessen Außenumfangsoberfläche dazu konfiguriert ist, eine Innenfläche (63) der Ummantelung (60) zu kontaktieren, und
die Füllharzbegrenzungsfläche einstückig mit dem Grundkörper (321; 321A; 321I) ausgebildet ist und an der der Öffnung (81) gegenüberliegenden Position angeordnet ist.

4. Elektronische Vorrichtung (510) nach einem der Ansprüche 1 bis 3,
wobei die Füllharzbegrenzungsfläche ein Element (323B; 323C; 323D) beinhaltet, dass sich in einer Axialrichtung der Ummantelung (60) erstreckt, wobei beide Seiten (324, 326) in Bezug auf die Erstreckungsrichtung des Elements (323B; 323C; 323D) dazu konfiguriert sind, die Innenfläche (63) der Ummantelung (60) über einen vorbestimmten Längenbereich parallel zur Axialrichtung der Ummantelung (60) zu kontaktieren.

5. Elektronische Vorrichtung (510) nach einem der Ansprüche 1 bis 3,
wobei die Füllharzbegrenzungsfläche ein Element (323A; 323E; 323F) beinhaltet, dass sich in einer Axialrichtung der Ummantelung (60) erstreckt, wobei zwischen dem Element (323A; 323E; 323F) und der Innenfläche (63) der Ummantelung (60) ein Abstand ausgebildet ist.

6. Elektronische Vorrichtung (510) nach einem der Ansprüche 1 bis 5,
wobei die Füllharzbegrenzungsfläche, an einer Oberfläche davon, die sich gegenüberliegend der Öffnung (81) befindet, einen sich in Axialrichtung der Ummantelung (60) erstreckenden Nutabschnitt (325; 328) aufweist.

7. Elektronische Vorrichtung (510) nach einem der Ansprüche 1 bis 6,
wobei die Füllharzbegrenzungsfläche derart bogenförmig ist, dass die der Öffnung (81) gegenüberliegende Oberfläche bei Betrachtung in einem Querschnitt in einer Richtung, die orthogonal zur axialen Richtung der Ummantelung (60) ist, konvex ist.

8. Elektronische Vorrichtung (510) nach einem der Ansprüche 1 bis 7,
wobei das Verschlusselement (70, 80) einen ersten Abschnitt (321; 321A; 321I) beinhaltet, wobei mindestens ein Teil dessen Außenumfangsoberfläche dazu konfiguriert ist, eine Innenfläche (63) der Ummantelung (60) zu kontaktieren, und einen zweiten Abschnitt (322; 322G; 322H; 322J) beinhaltet, der einstückig mit dem ersten Abschnitt (321; 321A; 321I) ausgebildet ist und bei Betrachtung in einem Querschnitt in einer Richtung, die orthogonal zur axialen Richtung der Ummantelung (60) ist, eine kleinere Form als der erste Abschnitt (321; 321A; 321I) aufweist, und
die Füllharzbegrenzungsfläche eine Außenumfangsoberfläche des zweiten Abschnitts (322; 322G; 322H; 322J) beinhaltet.

9. Elektronische Vorrichtung (510) nach einem der Ansprüche 1 bis 8,
wobei der erste Abschnitt (321) einen ausgeschnittenen Abschnitt (323) aufweist, der dazu konfiguriert ist, durchgehend mit der Außenumfangsoberfläche des zweiten Abschnitts (322) zu sein.

10. Elektronische Vorrichtung (510) nach einem der Ansprüche 1 bis 9,
wobei an der Außenumfangsoberfläche des zweiten Abschnitts (322H) ein Paar sich in der Axialrichtung der Ummantelung (60) erstreckende Vorsprünge (331) vorgesehen ist, und
das Verschlusselement (70, 80) derart angeordnet ist, dass ein Zwischenraum zwischen dem Paar Vorsprüngen (331) mit der Öffnung (81) in Verbindung steht.

11. Elektronische Vorrichtung (510) nach einem der Ansprüche 1 bis 10,
wobei an der Außenumfangsoberfläche des zweiten Abschnitts (322J) an der der Innenfläche (63) der Ummantelung (60) gegenüberliegenden Seite ein sich in einer Umfangsrichtung erstreckender Vorsprung (335) vorgesehen ist.

12. Elektronische Vorrichtung (510) nach einem der Ansprüche 1 bis 11,
wobei das Verschlusselement (70, 80) einen Grundkörper (321I) beinhaltet, dessen Außenumfangsoberfläche dazu konfiguriert ist, die Innenfläche (63) der Ummantelung (60) zu kontaktieren,
der Grundkörper (321I) einen ausgeschnittenen Abschnitt (334) aufweist, der derart konfiguriert ist, dass ein Abstand zwischen einer Außenfläche des ausgeschnittenen Abschnitts (334) und der Innenfläche (63) der Ummantelung (60) in einem Bereich von 0,2 mm bis 1,0 mm liegt, und
das Verschlusselement (70, 80) derart angeordnet ist, dass der ausgeschnittene Abschnitt (334) mit der Öffnung (81) in Verbindung steht.

13. Elektronische Vorrichtung (510) nach einem der Ansprüche 1 bis 12,
wobei die Ummantelung (60L) einen einem Ende davon einen Montageabschnitt (340) aufweist, an dem das Verschlusselement (70, 80) montiert ist,
der Montageabschnitt (340) derart konfiguriert ist, dass eine Innenfläche davon, an der das Verschlusselement (70, 80) montiert ist, in einer Richtung, die orthogonal zur axialen Richtung der Ummantelung (60L) verläuft, eine kleinere Querschnittsform aufweist, als ein anderer Abschnitt der Ummantelung (60L), und eine Hohlstruktur aufweist, die mit dem Inneren der Ummantelung (60L) in Verbindung steht, und
die Öffnung (81) nahe dem Montageabschnitt (340) vorgesehen ist, und die Dicke der Hohlstruktur so konfiguriert ist, dass sie in einem Bereich von 0,2 mm bis 1,0 mm liegt.

14. Elektronische Vorrichtung (510) nach einem der Ansprüche 1 bis 13,
wobei die Ummantelung (60M) an einem Ende davon einen Montageabschnitt (323M) aufweist, an dem das Verschlusselement (70, 80M) montiert ist,
der Montageabschnitt (323M) derart konfiguriert ist, dass eine Innenfläche davon, an der das Verschlusselement (70, 80M) montiert ist, eine kleinere Querschnittsform aufweist, als ein anderer Abschnitt der Ummantelung (60M), und eine Hohlstruktur aufweist, die mit dem Inneren der Ummantelung (60M) in Verbindung steht,
die Dicke der Hohlstruktur so konfiguriert ist, dass sie in einem Bereich von 0,2 mm bis 1,0 mm liegt,
das Verschlusselement (70, 80M) einen Grundkörper, der die Innenfläche des Montageabschnitts (323M) kontaktiert, und einen Vorsprung, dessen Außenumfangsoberfläche fortlaufend mit der Innenfläche der Hohlstruktur ist, beinhaltet, und
die Öffnung (81) in einem dem Montageabschnitt (323M) gegenüberliegenden Abschnitt oder einem dem Vorsprung des Verschlusselements (70, 80M) gegenüberliegenden Anschnitt vorgesehen ist, und eine der Öffnung (81) gegenüberliegende Oberfläche als die Füllharzbegrenzungsfläche dient.

15. Elektronische Vorrichtung (510), umfassend:
eine Ummantelung (60M), die rohrförmig ist und deren eines Ende geschlossen ist;
ein elektronisches Bauteil, das an einer durch die Ummantelung (60M) umschlossenen Position angeordnet ist; und
einen Harzabschnitt (120), der das Innere der Ummantelung (60M) ausfüllt und einen Ausdehnungskoeffizienten vom mindestens 90×10⁻⁶/°C und höchstens 400×10⁻⁶/°C aufweist,
wobei die Ummantelung (60M) an deren anderem Ende einen Vorsprung aufweist, deren Innenfläche eine kleinere Querschnittsform aufweist, als ein anderer Abschnitt der Ummantelung (60M), und der eine Hohlstruktur aufweist, die mit dem Inneren der Ummantelung (60M) in Verbindung steht,
die Ummantelung (60M) mit einer Öffnung (81) zum Füllen des Harzabschnitts (120) versehen ist, wobei die Öffnung (81) mit dem Inneren und dem Äußeren der Ummantelung (60M) in Verbindung steht, und
die Hohlstruktur des Vorsprungs die Dicke des Harzabschnitts (120) definiert, der durch die Öffnung (81) mit Harz in einem Bereich von 0,2 mm bis 1,0 mm gefüllt wird.

16. Elektronische Vorrichtung (510) nach einem der Ansprüche 1 bis 15,
wobei eine Anwendungstemperatur der oben beschriebenen elektronischen Vorrichtung in einem Bereich von -30°C bis 85°C liegt.

## Revendications

1. Dispositif électronique (510), comprenant :
un boîtier (60 ; 60K ; 60L ; 60M) qui est tubulaire et dont une extrémité est fermée ;
un élément de fermeture (70, 80 ; 80M) qui ferme une ouverture au niveau de l'autre extrémité du boîtier (60 ; 60K ; 60L ; 60M) ;
un composant électronique qui est disposé au niveau d'une position entourée par le boîtier (60 ; 60K ; 60L ; 60M) et l'élément de fermeture (70, 80 ; 80M) ; et
une section de résine (120) qui remplit l'intérieur du boîtier (60 ; 60K ; 60L ; 60M) et qui a un coefficient de dilatation linéaire supérieur ou égal à 90 x 10⁻⁶/°C et inférieur ou égal à 400 x 10⁻⁶/°C,
dans lequel le boîtier (60 ; 60K ; 60L ; 60M) est pourvu d'une entrée (81) permettant de remplir la section de résine (120), l'entrée (81) étant en communication avec l'intérieur et l'extérieur du boîtier (60 ; 60K ; 60L ; 60M), et
une surface de confinement de résine de remplissage est prévue à l'intérieur du boîtier (60 ; 60K ; 60L ; 60M), la surface de confinement de résine de remplissage étant au moins partiellement disposée au niveau d'une position en regard de l'entrée (81), et comprenant une région dont une distance à une surface intérieure (63 ; 63M) du boîtier (60 ; 60K ; 60L ; 60M) est supérieure ou égale à 0,2 mm et inférieure ou égale à 1,0 mm et dont une superficie fait au moins quatre fois la superficie de section transversale de l'entrée (81).

2. Dispositif électronique (510) selon la revendication 1,
dans lequel l'entrée (81) a une superficie de section transversale qui correspond à une superficie d'ouverture d'un cercle dont le diamètre s'inscrit dans une plage de 1,0 mm à 3,0 mm.

3. Dispositif électronique (510) selon la revendication 1 ou la revendication 2,
dans lequel l'élément de fermeture (70, 80) comprend une partie principale (321 ; 321A ; 321I) dont une surface circonférentielle extérieure est configurée pour se trouver en contact avec une surface intérieure (63) du boîtier (60), et
la surface de confinement de résine de remplissage est formée d'une seule pièce avec la partie principale (321 ; 321A ; 321I) et est disposée au niveau de la position en regard de l'entrée (81).

4. Dispositif électronique (510) selon l'une quelconque des revendications 1 à 3,
dans lequel la surface de confinement de résine de remplissage comprend un élément (323B ; 323C; 323D) qui se prolonge dans une direction axiale du boîtier (60), et les deux côtés (324 ; 326) par rapport à la direction de prolongement de l'élément (323B ; 323C ; 323D) sont configurés pour se trouver en contact avec la surface intérieure (63) du boîtier (60) sur une plage de longueur prédéterminée parallèlement à la direction axiale du boîtier (60).

5. Dispositif électronique (510) selon l'une quelconque des revendications 1 à 3,
dans lequel la surface de confinement de résine de remplissage comprend un élément (323A ; 323E ; 323F) qui se prolonge dans la direction axiale du boîtier (60), et un espace est formé entre l'élément (323A ; 323E ; 323F) et la surface intérieure (63) du boîtier (60).

6. Dispositif électronique (510) selon l'une quelconque des revendications 1 à 5,
dans lequel la surface de confinement de résine de remplissage comporte, sur sa surface en regard de l'entrée (81), une section de rainure (325 ; 328) s'étendant dans la direction axiale du boîtier (60).

7. Dispositif électronique (510) selon l'une quelconque des revendications 1 à 6,
dans lequel la surface de confinement de résine de remplissage a une forme d'arc de sorte que la surface en regard de l'entrée (81) soit convexe lorsqu'on la regarde selon une coupe transversale prise dans une direction orthogonale à la direction axiale du boîtier (60).

8. Dispositif électronique (510) selon l'une quelconque des revendications 1 à 7,
dans lequel l'élément de fermeture (70, 80) comprend une première section (321 ; 321A; 321I) dont au moins une partie de surface circonférentielle extérieure est configurée pour se trouver en contact avec la surface intérieure (63) du boîtier (60), et une seconde section (322 ; 322G ; 322H ; 322J) qui est formée d'une seule pièce avec la première section (321 ; 321A ; 321I) et qui a une forme plus petite que celle de la première section (321 ; 321A ; 321I) lorsqu'on la regarde selon la section transversale dans une direction orthogonale à la direction axiale du boîtier (60), et
la surface de confinement de résine de remplissage comprend une surface circonférentielle extérieure de la seconde section (322 ; 322G ; 322H ; 322J).

9. Dispositif électronique (510) selon l'une quelconque des revendications 1 à 8,
dans lequel la première section (321) comporte une section découpée (323) configurée pour être continue à la surface circonférentielle extérieure de la seconde section (322).

10. Dispositif électronique (510) selon l'une quelconque des revendications 1 à 9,
dans lequel deux saillies (331) qui s'étendent dans la direction axiale du boîtier (60) sont disposées sur la surface circonférentielle extérieure de la seconde section (322H), et
l'élément de fermeture (70, 80) est disposé de sorte qu'un espace séparant les deux saillies (331) soit en communication avec l'entrée (81).

11. Dispositif électronique (510) selon l'une quelconque des revendications 1 à 10,
dans lequel une saillie (335) qui s'étend dans une direction circonférentielle est disposée sur la surface circonférentielle extérieure de la seconde section (322J) du côté en regard de la surface intérieure (63) du boîtier (60).

12. Dispositif électronique (510) selon l'une quelconque des revendications 1 à 11,
dans lequel l'élément de fermeture (70, 80) comprend une partie principale (321I) dont une surface circonférentielle extérieure est configurée pour se trouver en contact avec la surface intérieure (63) du boîtier (60),
la partie principale (321I) comporte une section découpée (334) qui est configurée de sorte qu'une distance séparant une surface extérieure de la section découpée (334) et la surface intérieure (63) du boîtier (60) s'inscrive dans une plage de 0,2 mm à 1,0 mm, et
l'élément de fermeture (70, 80) est conçu de sorte que la section découpée (334) soit en communication avec l'entrée (81).

13. Dispositif électronique (510) selon l'une quelconque des revendications 1 à 12,
dans lequel le boîtier (60L) comporte, sur une de ses extrémités, une section d'ajustement (340) avec laquelle s'ajuste l'élément de fermeture (70, 80),
la section d'ajustement (340) est configurée de sorte que sa surface intérieure à laquelle s'ajuste l'élément de fermeture (70, 80) ait une forme de section transversale plus petite dans une direction orthogonale à la direction axiale du boîtier (60L) que celle d'une autre section du boîtier (60L), et a une structure creuse qui est en communication avec l'intérieur du boîtier (60L), et
l'entrée (81) est disposée à proximité de la section d'ajustement (340), et l'épaisseur de la structure creuse est configurée pour s'inscrire dans une plage de 0,2 mm à 1,0 mm.

14. Dispositif électronique (510) selon l'une quelconque des revendications 1 à 13,
dans lequel le boîtier (60M) comporte, sur une de ses extrémités, une section d'ajustement (323M) à laquelle s'ajuste l'élément de fermeture (70, 80M),
la section d'ajustement (323M) est configurée de sorte que sa surface intérieure à laquelle s'ajuste l'élément de fermeture (70, 80M) ait une forme de section transversale plus petite que celle d'une autre section du boîtier (60M) et a une structure creuse qui est en communication avec l'intérieur du boîtier (60M),
l'épaisseur de la structure creuse est configurée pour s'inscrire dans une plage de 0,2 mm à 1,0 mm,
l'élément de fermeture (70, 80M) comprend une partie principale qui est en contact avec la surface intérieure de la section d'ajustement (323M), et une saillie dont la surface circonférentielle extérieure est continue avec la surface intérieure de la structure creuse, et
l'entrée (81) est disposée dans une section en regard de la section d'ajustement (323M) ou dans une section en regard de la saillie de l'élément de fermeture (70, 80M), et une surface située en regard de l'entrée (81) sert de surface de confinement de résine de remplissage.

15. Dispositif électronique (510), comprenant :
un boîtier (60L) qui est tubulaire et dont une extrémité est fermée ;
un composant électronique qui est disposé au niveau d'une position enfermée par le boîtier (60L) ; et
une section de résine (120) qui remplit l'intérieur du boîtier (60L) et qui a un coefficient de dilatation linéaire supérieur ou égal à 90 x 10⁻⁶/°C et inférieur ou égal à 400 x 10⁻⁶/°C,
dans lequel le boîtier (60L) comporte, sur son autre extrémité, une saillie courbée vers l'intérieur (340) dont une surface intérieure a une forme de section transversale plus petite que celle d'une autre section du boîtier (60L) et qui a une structure creuse (320L) qui est en communication avec l'intérieur du boîtier (60L)
le boîtier (60L) est pourvu d'une entrée (81) permettant de remplir la section de résine (120), l'entrée (81) étant en communication avec l'intérieur et l'extérieur du boîtier (60L) et
la structure creuse (320L) de la saillie (340) définit l'épaisseur, s'inscrivant dans une plage de 0,2 mm à 1,0 mm, de la résine qui remplit la structure creuse (320L) à partir de l'entrée (81).

16. Dispositif électronique (510) selon l'une quelconque des revendications 1 à 15,
dans lequel une température d'application du dispositif électronique décrit ci-dessus s'inscrit dans une plage de -30 °C à 85 °C.
